# EUROPÄISCHE PATENTANMELDUNG

(11) **EP 4 297 432 A1**
(43) Veröffentlichungstag der Anmeldung: **27.12.2023**
(21) Anmeldenummer: 22180086.5
(22) Anmeldetag: 21.06.2022
(51) Int. Cl.: H04R 19/00, H04R 17/00, H04R 31/00, H04R 7/14, B81C 1/00

(54) **VERFAHREN ZUR HERSTELLUNG EINES MEMS-WANDLERS UNTER NUTZUNG EINER VERSTRECKUNG EINES AKTUATORMATERIALS**

(71) Anmelder: Hahn-Schickard-Gesellschaft für angewandte Forschung e.V., 78052 Villingen-Schwenningen (DE)
(72) Erfinder: Bittner, Achim, 74080 Heilbronn (DE); Becker, Dennis, 78166 Donaueschingen (DE); Keller, Steffen, 78462 Konstanz (DE); Dehé, Alfons, 72770 Reutlingen (DE)
(74) Vertreter: Hertin und Partner Rechts- und Patentanwälte PartG mbB

(57) **Zusammenfassung**

Die Erfindung betrifft ein Verfahren zur Herstellung eines MEMS-Wandlers zur Interaktion mit einem Volumenstrom eines Fluids. Zu diesem Zweck werden zunächst eine Formgebungskomponente zur Ausbildung einer schwingfähigen Membran mit einer Aktuatorlage in Form einer Mäanderstruktur sowie ein Aktuatormaterial umfassend Polymere bereitgestellt, wobei das Aktuatormaterial in Form einer Polymerfolie oder einer Polymerflüssigkeit vorliegt. Um die Formausgestaltung der Aktuatorlage der schwingfähigen Membran zu erhalten, wird die Formgebungskomponente mit dem Aktuatormaterial kontaktiert. Vorteilhaft werden während der Kontaktierung der Formgebungskomponente mit dem Aktuatormaterial die Polymere des Aktuatormaterials ausgerichtet und/oder verstreckt, sodass ein Dipolmoment der Polymere und piezoelektrische Eigenschaften des Aktuatormaterials verstärkt werden.

In einem weiteren Aspekt betrifft die Erfindung einen MEMS-Wandler, welcher mittels des Verfahrens herstellbar ist.

## Beschreibung

Die Erfindung betrifft ein Verfahren zur Herstellung eines MEMS-Wandlers zur Interaktion mit einem Volumenstrom eines Fluids. Zu diesem Zweck werden zunächst eine Formgebungskomponente zur Ausbildung einer schwingfähigen Membran mit einer Aktuatorlage in Form einer Mäanderstruktur sowie ein Aktuatormaterial umfassend Polymere bereitgestellt, wobei das Aktuatormaterial in Form einer Polymerfolie oder einer Polymerflüssigkeit vorliegt. Um die Formausgestaltung der Aktuatorlage der schwingfähigen Membran zu erhalten, wird die Formgebungskomponente mit dem Aktuatormaterial kontaktiert. Vorteilhaft werden während der Kontaktierung der Formgebungskomponente mit dem Aktuatormaterial die Polymere des Aktuatormaterials ausgerichtet und/oder verstreckt, sodass ein Dipolmoment der Polymere und piezoelektrische Eigenschaften des Aktuatormaterials verstärkt werden.

In einem weiteren Aspekt betrifft die Erfindung einen MEMS-Wandler, welcher mittels des Verfahrens herstellbar ist.

### Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (engl. microelectromechanical system, kurz MEMS) sind sehr kompakt (Mikrometerbereich) bei gleichzeitig hervorragender Funktionalität und immer geringeren Herstellungskosten.

Aus dem Stand der Technik sind auch MEMS-Wandler, wie beispielsweise MEMS-Lautsprecher oder MEMS-Mikrofone, bekannt. Derzeitige MEMS-Lautsprecher werden zumeist als planare Membransysteme ausgeführt mit einer vertikalen Aktuierung einer schwingfähigen Membran in Emissionsrichtung. Die Anregung erfolgt beispielsweise mittels piezoelektrischer, elektromagnetischer oder elektrostatischer Aktuatoren.

Ein elektromagnetischer MEMS-Lautsprecher für Mobilgeräte wird in Shahosseini et al. 2015 beschrieben. Der MEMS-Lautsprecher weist eine versteifende Silizium-Mikrostruktur als Schallstrahler auf, wobei der bewegliche Teil an einem Träger über Silizium-Triebfedern aufgehangen wird, um große Verschiebungen mittels eines elektromagnetischen Motors aus der Ebene zu ermöglichen.

Stoppel et al. 2017 offenbart einen Zwei-Wege Lautsprecher dessen Konzept auf konzentrischen piezoelektrischen Aktuatoren basiert. Als eine Besonderheit ist die Schwingungsmembran nicht geschlossen ausgeführt, sondern umfasst acht piezoelektrische unimorphe Aktoren, die jeweils aus einer piezoelektrischen und einer passiven Schicht bestehen. Die äußeren Tieftöner bestehen aus vier einseitig eingespannten Aktuatoren mit Trapezform, während die inneren Hochtöner durch vier dreieckige Aktuatoren gebildet werden, welche mittels einer oder mehrerer Feder mit einem starren Rahmen verbunden sind. Die Trennung der Membran soll ein verbessertes Klangbild bei höherer Leistung erlauben.

Nachteilig an derartigen planaren MEMS-Lautsprechern ist deren Limitierung in Bezug auf die Schallleistung, insbesondere bei tiefen Frequenzen. Ein Grund hierfür liegt darin, dass der erzeugbare Schalldruckpegel proportional zum Quadrat der Frequenz für eine vorgegebene Auslenkung ist. Für hinreichende Schallleistungen sind daher entweder Auslenkungen für die Schwingungsmembranen von mindestens 100 µm oder großflächige Membranen im Quadratzentimeterbereich notwendig. Beide Bedingungen sind mittels einer MEMS-Technologie nur schwer zu realisieren.

Im Stand der Technik wurde daher vorgeschlagen MEMS-Lautsprecher zu konzipieren, welche nicht eine geschlossene Membran zu Schwingungen in vertikaler Emissionsrichtung aufweisen, sondern eine Vielzahl von beweglichen Elementen, die zu lateralen bzw. horizontalen Schwingungen angeregt werden können. Vorteilhaft hieran ist, dass auf kleiner Fläche ein vergrößerter Volumenstrom bewegbar und somit einer erhöhte Schallleistung bereitgestellt werden kann.

Ein auf diesem Prinzip basierender MEMS-Lautsprecherwird beispielsweise in der US 2018/0179048 A1 bzw. Kaiser et al. 2019 offenbart. Der MEMS-Lautsprecher umfasst eine Mehrzahl elektrostatischer Biegeaktuatoren, welche zwischen einem Deckel- und Boden-Wafer als vertikale Lamellen angeordnet vorliegen und durch entsprechende Steuerung zu lateralen Schwingungen angeregt werden können. Hierbei bildet eine innere Lamelle eine Aktuatorelektrode gegenüber zwei äußeren Lamellen. Bis auf einen Verbindungsknoten von weiterhin galvanisch getrennten Elektroden besteht ein Luftspalt zwischen den gebogenen drei Lamellen. Liegt ein Potential innen gegen außen an, führt dies zu einer beidseitigen Anziehung aufgrund der Wölbung des Designs in Richtung einer Vorzugsrichtung, welche durch einen Anker vorgegeben ist. Die Ausbuchtungen der äußeren Lamellen dienen der Beweglichkeit. Die Rückstellkraft ist durch eine mechanische Federkraft gegeben. Ein pull-push Betrieb ist somit nicht möglich.

Nachteilig ist zudem, dass Spalten zwischen den Biegeaktuatoren und den Deckel/Boden-Wafern, welche für deren Beweglichkeit notwendig sind, zu einer Ventilation zwischen beiden Kammern führen. Hierdurch erfährt die untere Grenzfrequenz eine Begrenzung. Weiterhin ist die laterale Bewegung der Biegeaktuatoren und mithin die Schallleistung eingeschränkt, um einen pull-in Effekt und akustischen Durchschlag zu vermeiden.

In der WO 2021/144400 A1 wird ein MEMS-Wandler offenbart, der sowohl als MEMS-Lautsprecher als auch als MEMS-Mikrofon eingesetzt werden kann. Der darin beschriebene MEMS-Wandler weist eine schwingfähige Membran auf, die derart aufgebaut ist, dass sie zwei oder mehr vertikale Abschnitte umfasst, welche im Wesentlichen parallel zur vertikalen Richtung ausgebildet sind. Weiterhin umfasst die schwingfähige Membran mindestens eine Lage aus einem Aktuatormaterial und ist zumindest mit einer Elektrode endseitig kontaktiert. Hierdurch können die vertikalen Abschnitte über eine Ansteuerung der Elektrode zu horizontalen Schwingungen angeregt werden. Umgekehrt kann auch bei einer Anregung der vertikalen Abschnitte zu horizontalen Schwingungen an der Elektrode ein elektrisches Signal erzeugt werden.

Der in der WO 2021/144400 A1 offenbarte MEMS-Wandler weist deutliche Verbesserungen gegenüber dem Stand der Technik auf. Die Gestaltung der schwingfähigen Membran umfassend die vertikalen Abschnitte führt im Falle eines MEMS-Lautsprechers vorteilhaft zu einer höheren Schallleistung, wobei die Kontaktierung gleichzeitig eine vereinfachte Ansteuerbarkeit gewährleistet. Auch im Falle eines MEMS-Mikrofons wird vorteilhaft eine höhere Leistungsfähigkeit sowie Audioqualität mit einem geeigneten Klangbild ermöglicht. Zudem kann für die Herstellung des MEMS-Wandlers auf bewährte Prozesse der Halbleiterprozessierung zurückgegriffen werden, sodass eine kosteneffiziente Produktion ermöglicht wird.

Der in der WO 2021/144400 A1 offenbarte MEMS-Wandlerwird bevorzugt hergestellt, in dem ein Substrat geätzt wird, vorzugsweise von einer Vorderseite, um eine Mäanderstruktur auszubilden. Daraufhin werden mindestens zwei Lagen aufgebracht, wobei mindestens eine erste Lage ein Aktuatormaterial und eine zweite Lage ein mechanisches Stützmaterial umfasst oder mindestens zwei Lagen umfassend ein Aktuatormaterial beschichtet werden. Anschließend werden die erste und/oder die zweite Lage mit einer Elektrode kontaktiert.

Insbesondere hinsichtlich des Herstellungsverfahrens des in der WO 2021/144400 A1 offenbarten MEMS-Wandlers besteht ein Potential zur Optimierung. So ist insbesondere die Aufbringung des Aktuatormaterials an die im Substrat ausgebildete Mäanderstruktur aufwendig, um eine homogene Beschichtung zu gewährleisten. Eine gleichförmige Ausgestaltung der schwingfähigen Membran ist jedoch von großer Bedeutung für die akustische Performance.

Allen im Stand der Technik bekannten MEMS-Wandlern, wie MEMS-Lautsprecher oder MEMS-Mikrofonen, sind gemein, dass der schwingfähigen Membran eine besondere Bedeutung zukommt. Erst die Auslenkung der Membran erlaubt die Detektion oder Erzeugung eines Signals. Der Materialauswahl als solche ist eine besondere Bedeutung beizumessen, insbesondere der Materialauswahl des Aktuatormaterials, welches in dem Herstellungsverfahren des in der WO 2021/144400 A1 offenbarten MEMS-Wandlers zur Auftragung auf die Mäanderstruktur des Substrats eingesetzt wird. Einerseits müssen gewünschte akustische, mechanische und elektrische Eigenschaften erfüllt sein, um eine geeignete Funktionstauglichkeit des MEMS-Wandlers zu ermöglichen. Andererseits muss das Material auch einfach zu prozessieren sein, um die Herstellung der Membran und damit auch des MEMS-Wandlers optimal ausführen zu können.

Im Lichte des Standes der Technik liegt mithin ein Bedarf vor, verbesserte oder alternative Verfahren zur Herstellung eines MEMS-Wandlers zu bieten.

### Aufgabe der Erfindung

Aufgabe der Erfindung war es, die Nachteile des Standes der Technik zu beseitigen. Insbesondere war es eine Aufgabe der Erfindung, ein Verfahren zur Herstellung von MEMS-Wandlern bereitzustellen, welches sich durch eine hohe Prozesseffizienz auszeichnet und auf zuverlässige Weise zu einem leistungsstarken MEMS-Wandler mit erwünschten akustischen Eigenschaften führt.

### Zusammenfassung der Erfindung

Die Aufgabe der Erfindung wird gelöst durch die unabhängigen Ansprüche. Vorteilhafte Ausgestaltungen der Erfindung sind in den abhängigen Ansprüchen offenbart.

In einem ersten Aspekt betrifft die Erfindung ein Verfahren zur Herstellung eines MEMS-Wandlers zur Interaktion mit einem Volumenstrom eines Fluids umfassend
- einen Träger
- eine schwingfähige Membran zur Erzeugung oder Aufnahme von Druckwellen des Fluids in einer vertikalen Richtung, wobei die schwingfähige Membran von dem Träger gehalten wird,
die schwingfähige Membran eine Mäanderstruktur mit vertikalen Abschnitten und horizontalen Abschnitten aufweist, wobei die vertikalen Abschnitte im Wesentlichen parallel zur vertikalen Richtung ausgebildet sind und die horizontalen Abschnitte die vertikalen Abschnitte miteinander verbinden, und wobei die schwingfähige Membran mindestens eine Aktuatorlage aus einem Aktuatormaterial umfasst und mit mindestens einer Elektrode kontaktiert vorliegt, sodass durch Ansteuerung der mindestens einen Elektrode die vertikalen Abschnitte zu horizontalen Schwingungen angeregt werden können oder sodass bei Anregung der vertikalen Abschnitte zu horizontalen Schwingungen an der mindestens einen Elektrode ein elektrisches Signal erzeugt werden kann, wobei das Verfahren folgende Schritte umfasst:
a) Bereitstellung mindestens einer Formgebungskomponente zur Ausbildung der schwingfähigen Membran mit der Aktuatorlage in Form einer Mäanderstruktur,
b) Bereitstellung eines Aktuatormaterials umfassend Polymere, wobei das Aktuatormaterial in Form einer Polymerfolie oder einer Polymerflüssigkeit vorliegt,
c) Kontaktierung der Formgebungskomponente mit dem Aktuatormaterial für eine Formausgestaltung der Aktuatorlage, wobei während der Kontaktierung der Formgebungskomponente mit dem Aktuatormaterial die Polymere des Aktuatormaterials ausgerichtet und/oder verstreckt werden, sodass ein Dipolmoment der Polymere erhöht und piezoelektrische Eigenschaften des Aktuatormaterials verstärkt werden.

Das bevorzugte Verfahren zur Herstellung eines MEMS-Wandlers hat sich in einer Vielzahl von Aspekten als vorteilhaft erwiesen.

Ein besonderer Vorteil ist, dass insbesondere durch den Einsatz eines Aktuatormaterials umfassend Polymere sowie der Ausrichtung und/oder Verstreckung der Polymere die piezoelektrischen Eigenschaften des Aktuatormaterials verstärkt werden können. Eine Verstärkung der piezoelektrischen Eigenschaften meint bevorzugt, dass physikalische Parameter hinsichtlich des piezoelektrischen Effektes vorteilhaft erhöht werden können. Relevante physikalische Parameter betreffen bevorzugt piezoelektrische Ladungskoeffizienten, piezoelektrische Spannungskoeffizienten und/oder piezoelektrische Kopplungskoeffizienten.

Die bevorzugte Kontaktierung der Formgebungskomponente mit dem Aktuatormaterial für eine Formausgestaltung der Aktuatorlage dient insbesondere der Bereitstellung der schwingfähigen Membran des MEMS-Wandlers. Durch die Verstärkung der piezoelektrischen Eigenschaften wird es vorteilhaft ermöglicht, eine schwingfähige Membran bereitzustellen, die bei einer Auslenkung der vertikalen Abschnitte ein entsprechend höheres elektrisches Messsignal erzeugt. Umgekehrt kann durch die Anlegung einer elektrischen Spannung eine höhere Auslenkung der vertikalen Abschnitte generiert werden, sodass ein höherer Volumenstrom ausgestoßen werden kann. Demzufolge eignet sich das bevorzugte Verfahren hervorragend für die Bereitstellung eines leistungsstarken MEMS-Mikrofons oder eines MEMS-Lautsprechers als MEMS-Wandler mit gewünschten akustischen Eigenschaften.

Erfindungsgemäß wurde erkannt, dass ein Aktuatormaterial umfassend Polymere mit der Eigenschaft, im Falle einer Ausrichtung und/oder Verstreckung der Polymere verstärkte piezoelektrische Eigenschaften zu erlangen, sich hervorragend eignet, um in einem Verfahren zur Herstellung eines MEMS-Wandler eingesetzt zu werden. Hierbei kann mit geringem Materialaufwand und unter effizienter Prozessführung eine besonders leistungsstarke Aktuatorlage gewährleistet werden, welche zu einer hohen Sensitivität im Falle eines MEMS-Mikrofons oder einer hohen Leistungsstärke im Falle eines MEMS-Lautsprechers führt.

Der vorteilhafte Effekt der Erhöhung der piezoelektrischen Eigenschaften beruht bevorzugt hierbei auf einer Erhöhung des Dipolmomentes der Polymere des Aktuatormaterials. Im erfindungsgemäßen Kontext ist mit dem Dipolmoment bevorzugt ein elektrisches Dipolmoment gemeint, welches als Maß für die räumliche Ladungstrennung, mithin bevorzugt ein Maß für die Stärke des Dipolcharakters der Polymere des Aktuatormaterials, darstellt.

Ohne auf die Theorie beschränkt sein zu wollen, ist es im erfindungsgemäße Kontext bevorzugt, dass eine Verstärkung der piezoelektrischen Eigenschaften der gebildeten Aktuatorlage durch die Ausrichtung und/oder Verstreckung der Polymere des Aktuatormaterials erfolgt. Für die Einstellung der optimierten piezoelektrischen Eigenschaften kommt der molekulare und/oder submolekulare Struktur der Polymere eine Relevanz zu.

Mit einer Verstreckung ist bevorzugt gemeint, dass durch die Kontaktierung der Formgebungskomponente mit dem Aktuatormaterial die Atome und/oder Moleküle eines Polymers eine höheren Abstand zueinander erlangen, wodurch sich bevorzugt die räumliche Trennung der Partialladungen der Atome und/oder Moleküle erhöht. Dementsprechend liegt eine Polarisation vor und die piezoelektrischen Eigenschaften werden verstärkt.

Mit einer Ausrichtung ist bevorzugt gemeint, dass die Moleküle und/oder Atome der Polymere des Aktuatormaterials derart angeordnet werden, dass es zu einer orientierten Ladungsverteilung kommt, um die piezoelektrischen Eigenschaften zu verstärken. So umfasst eine Ausrichtung bevorzugt eine Anordnung der Atome und/oder Moleküle mit unterschiedlichen Elektronegativitäten, um das Dipolmoment zu erhöhen. Insbesondere werden Atome und/oder Moleküle mit einer hohen Elektronegativität und einer niedrigen Elektronegativität derart ausgerichtet, dass die Polarisation und damit die piezoelektrischen Eigenschaften erhöht werden. Dabei kann es bevorzugt sein, dass bestimmte Materialphasen durch die Ausrichtung der Atome und/oder Moleküle erlangt werden. So kann beispielsweise im Falle von Polyvinyldifluorid (PVDF) durch eine Ausrichtung der Polymere eine β-Phase erreicht werden, welche sich im erfindungsgemäßen Kontext als besonders vorteilhaft erwiesen hat.

Die bevorzugten Verfahrensschritte eignen sich besonders gut, um eine leistungsfähige Aktuatorlage (d. h. das Aktuatormaterial nach der Kontaktierung mit der Formgebungskomponente) als Bestandteil einer schwingfähige Membran bereitzustellen, welche durch die verstärkten piezoelektrischen Eigenschaften eine hervorragende Performance aufweist. Auch hinsichtlich der Prozessierung ergeben sich eine Reihe von Vorteilen.

So sind vorteilhaft auf hybride Weise MEMS-Wandler herstellbar, indem der Einsatz eines Aktuatormaterials umfassend Polymere erfolgt. Daher kann die Skalierung der Herstellung vorteilhaft kostengünstig sein. Insbesondere können Kosten für Ausrüstung und Fertigungsinfrastruktur im Vergleich zur CMOS-Fertigung (englisch: complementary metal-oxidesemiconductor) anwendungsabhängig niedriger sein. Der Einsatz eines Aktuatormaterials umfassend Polymere begünstigt die Herstellung, da Polymere kostengünstig zu erwerben, einfach in ihrer Verarbeitung sind und eine hohe mechanische Flexibilität aufweisen. Sowohl in flüssiger Form als auch als Polymerfolie kann die Aktuatorlage vorteilhaft besonders homogen auf die Formgebungskomponente aufgetragen werden, wobei durch Verstreckung und/oder Ausrichtung gleichzeitig erhöhte piezoelektrische Eigenschaften des Aktuatormaterials gewährleistet werden.

Gleichzeitig kann zudem auf einfache Weise ein weiteres Material, z. B. ein mechanisches Stützmaterial und/oder ein elektrisch leitfähiges Material, auf die Aktuatorlage aufgebracht werden. Dementsprechend ist es möglich, auf einer Vorder- und Rückseite der Aktuatorlage eine mechanische Stabilität, Schutzfunktion und/oder Kontaktierung für die Aktuatorlage bereitzustellen. Die weiteren Lage (z. B. ein mechanisches Stützmaterial und/oder ein elektrisch leitfähiges Material) kann sowohl vor als auch nach der Kontaktierung mit der Formgebungskomponente aufgetragen werden, sodass eine hohe Flexibilität hinsichtlich der Prozessführung vorliegt.

Das bevorzugte Verfahren erlaubt es vorteilhafterweise zudem, auf besonders präzise Weise die schwingfähigen Membran zu formen. So können vorteilhaft durch die Kontaktierung der Formgebungskomponente mit dem Aktuatormaterial besonders feine Abmessungen der vertikalen und/oder horizontalen Abschnitte der schwingfähigen Membran erlangt werden, wobei gleichzeitig eine gleichmäßige Ausgestaltung der Aktuatorlage gewährleistet wird.

Das bevorzugte Verfahren ist zudem einfach und schnell durchzuführen, benötigt vergleichsweise kostengünstige Materialien, Komponenten und/oder Anlagen und zeichnet sich durch eine hohe Prozesseffizienz aus.

Bevorzugt wird zunächst eine Formgebungskomponente bereitgestellt. Die Formgebungskomponente dient bevorzugt der Kontaktierung mit dem Aktuatormaterial, um die Aktuatorlage auszubilden.

Das Aktuatormaterial umfassend Polymere liegt vorzugsweise in Form einer Polymerfolie oder eine Polymerflüssigkeit vor. Bevorzugt erfolgt eine Kontaktierung der Formgebungskomponente mit dem Aktuatormaterial für eine Formausgestaltung der Aktuatorlage. Mit der Formausgestaltung ist bevorzugt eine Etablierung der Form bzw. der Struktur der schwingfähigen Membran gemeint. Insbesondere betrifft die Formausgestaltung den Erhalt der Aktuatorlage, nachdem die Formgebungskomponente mit dem Aktuatormaterial kontaktiert wird. Bevorzugt betrifft die Formausgestaltung die Ausbildung einer Mäanderstruktur, die vertikale Abschnitte und horizontale Abschnitte aufweist.

Während der Kontaktierung der Formgebungskomponente mit dem Aktuatormaterial werden die Polymere des Aktuatormaterial ausgerichtet und/oder verstreckt, sodass ein Dipolmoment der Polymere erhöht und piezoelektrische Eigenschaften des Aktuatormaterials verstärkt werden. Im Stand der Technik sind Materialien beschrieben, die an Polarisation gewinnen und damit ausgeprägte piezoelektrische Eigenschaften erlangen. Diese werden z. B. in Da Silva et al. (2010) und Gade, Bokka & Chase (2021) beschrieben. In Da Silva et al. (2010) wird gezeigt, dass die β-Phase von PVDF durch eine Kristallisation von N,N-Dimethylformamid-Lösung erhalten werden kann. In Gade, Bokka & Chase (2021) wird auf Herstellung von PVDF-Fasermatten und Fasergarnen und die Messung ihrer Ladung mit einer speziellen Konstruktion eines Faradayschen Käfigs eingegangen. Hinweise auf eine Anwendbarkeit zur Herstellung eines MEMS-Wandlers erhält der Fachmann nicht. Die Erfinder haben jedoch erkannt, dass sich Materialien umfassend Polymere, welche bei einer Verstreckung und/oder Ausrichtung der Polymere eine erhöhte Polarisation erlangen, sich besonders gut für eine Bereitstellung einer Aktuatorlage für einen MEMS-Wandler eignen. Neben der hohen Prozesseffizienz kommt hierbei insbesondere die erhöhte Leistungsfähigkeit der Aktuatorlage aufgrund der einstellbaren Polarisation bei gleichzeitig ausgezeichnetem Klangverhalten zum Tragen.

Vorteilhafterweise kann durch das bevorzugte Verfahren mithin ein hinsichtlich seiner akustischen Eigenschaften besonders geeigneter MEMS-Wandler bereitgestellt werden.

Die Konstruktionsweise des MEMS-Wandlers verbindet vorteilhaft die Möglichkeit hoher Schalleistung mit einer vereinfachten Ansteuerung. Im Gegensatz zu bekannten planaren MEMS-Lautsprechen muss beispielsweise die schwingfähige Membran selbst nicht über eine große Fläche von mehreren Quadratzentimeter oder mit Auslenkungen von mehr als 100 µm betrieben werden, um einen ausreichenden Schalldruck zu erzeugen. Stattdessen kann die Mehrzahl der vertikalen Abschnitte der schwingfähigen Membran mit kleinen horizontalen bzw. lateralen Bewegungen von wenigen Mikrometern eine vergrößertes Gesamtvolumen in vertikaler Emissionsrichtung bewegen.

Gleichzeitig kann eine vereinfachte Ansteuerung erreicht werden. Während im Stand der Technik, wie u.a. in der US 2019 / 011 64 17 A1, eine Vielzahl von piezoelektrischen Aktuatoren an den horizontalen Abschnitten kontaktiert werden müssen, kann der hier beschriebene MEMS-Lautsprecher mittels mindestens einer vorzugsweise endseitigen Elektrode betrieben werden. Dies reduziert den Herstellungsaufwand, minimiert Fehlerquellen und führt zudem inhärent zu einer synchronen Steuerung der vertikalen Abschnitte zu horizontalen Schwingungen.

Auf diese Weise können die Luftvolumina, welche zwischen den vertikalen Abschnitten vorliegen, überaus präzise durch die horizontalen Schwingungen entlang der vertikalen Emissionsrichtung bewegt werden.

Ebenso wird auf diese Weise die Bereitstellung eines besonders leistungsstarken MEMS-Mikrofones mit hoher Audioqualität ermöglicht. Der Aufbau des MEMS-Mikrofons ähnelt strukturell dem des MEMS-Lautsprechers, insbesondere im Hinblick auf die Ausgestaltung der schwingfähigen Membran. Anstelle einer Ansteuerung der Elektroden zur Erzeugung von horizontalen Schwingungen und mithin von Schalldruckwellen, ist das MEMS-Mikrofon jedoch dafür ausgelegt, Schalldruckwellen in selbiger vertikaler Richtung aufzunehmen. Bevorzugt liegen zwischen den vertikalen Abschnitten mithin Luftvolumina vor, welche bei Aufnahme von Schallwellen entlang einer vertikalen Detektionsrichtung bewegt werden. Durch die Schalldruckwellen werden die vertikalen Abschnitte zu horizontalen Schwingungen angeregt, sodass das Aktuatormaterial ein entsprechendes periodisches elektrisches Signal erzeugt.

Für die Leistungsfähigkeit und das Schwingungsverhalten der Membran haben sich sowohl im Hinblick auf Anwendungen als MEMS-Lautsprecher als auch als MEMS-Mikrofon die erhaltenen Aktuatorlagen mit verstärkten Polarisationseigenschaften als überaus vorteilhaft erwiesen.

Der herstellbare MEMS-Wandler weist zudem eine geringe Komplexität auf und erlaubt die einfache Durchführung weiterer Prozessierungsschritte, beispielsweise die geeignete Platzierung einer Top- und/oder Bottom-Elektrode auf der schwingfähigen Membran.

Das bevorzugte Verfahren dient insbesondere der Herstellung eines MEMS-Wandlers. Unter dem Begriff MEMS-Wandler ist sowohl ein MEMS-Mikrofon als auch ein MEMS-Lautsprecher zu verstehen. Allgemein bezeichnet der MEMS-Wandler einen Wandler zur Interaktion mit einem Volumenstrom eines Fluids, der auf MEMS-Technologie basiert und dessen Strukturen zur Interaktion mit dem Volumenstrom bzw. zur Aufnahme oder Erzeugung von Druckwellen des Fluids eine Dimensionierung im Mikrometerbereich (1 µm bis 1 000 µm) aufweisen. Bei dem Fluid kann es sich sowohl um ein gasförmiges als auch flüssiges Fluid handeln. Die Strukturen des MEMS-Wandlers, insbesondere der schwingfähigen Membran, sind zur Erzeugung oder Aufnahme von Druckwellen des Fluids ausgelegt.

Beispielsweise kann es sich, wie im Falle eines MEMS-Lautsprechers oder MEMS-Mikrofons, um Schalldruckwellen handeln. Der MEMS-Wandler kann sich aber ebenso als Aktuator oder Sensor für andere Druckwellen eignen. Der MEMS-Wandler ist somit bevorzugt eine Vorrichtung oder ein Gerät, welches Druckwellen (z.B. akustische Signale als Schallwechseldrücke) in elektrische Signale umwandelt oder umgekehrt (Umwandlung elektrischer Signale in Druckwellen, beispielsweise akustische Signale).

Auch Anwendungen des MEMS-Wandlers als ein Energy-Harvester sind möglich, wobei pneumatische oder hydraulische Wechseldrücke genutzt werden. Das elektrische Signal kann in diesen Fällen als gewonnene elektrische Energie abgeführt, gespeichert oder anderen (Verbraucher-)geräten zugeführt werden.

Ein MEMS-Lautsprecher bezeichnet bevorzugt einen Lautsprecher, welcher auf MEMS-Technologie basiert und dessen klangerzeugende Strukturen mindestens teilweise eine Dimensionierung im Mikrometerbereich (1 µm bis 1000 µm) aufweisen. Bevorzugt können beispielsweise die vertikalen Abschnitte der schwingfähigen Membran in Breite, Höhe und/oder Dicke eine Dimension im Bereich von weniger als 1000 µm aufweisen. Hierbei kann es auch bevorzugt sein, dass beispielsweise lediglich die Höhe der vertikalen Abschnitte im Mikrometerbereich dimensioniert sind, während beispielsweise die Länge eine größere Dimension und/oder die Dicke eine kleinere Größe aufweisen kann.

Ein MEMS-Mikrofon bezeichnet bevorzugt ein Mikrofon, welches auf einer MEMS-Technologie basiert und dessen klangaufnehmende Strukturen mindestens teilweise eine Dimensionierung im Mikrometerbereich (1 µm bis 1000 µm) aufweisen. Bevorzugt können beispielsweise die vertikalen Abschnitte der schwingfähigen Membran in Breite, Höhe und/oder Dicke eine Dimension im Bereich von weniger als 1000 µm aufweisen. Hierbei kann es auch bevorzugt sein, dass beispielsweise lediglich die Höhe der vertikalen Abschnitte im Mikrometerbereich dimensioniert sind, während beispielsweise die Länge eine größere Dimension und/oder die Dicke eine kleinere Größe aufweisen kann.

Bevorzugt umfasst der MEMS-Wandler die schwingfähige Membran zur Erzeugung oder Aufnahme von Druckwellen des Fluids in einer vertikalen Richtung. Damit bezeichnet die schwingfähige Membran diejenige Struktur, die es ermöglicht, ein elektrisches Signal nach einer Aufnahme von Druckwellen zu generieren oder durch die Aufbringung eines elektrischen Signals Druckwellen zu erzeugen. Dazu ist es bevorzugt, dass die schwingfähige Membran mindestens eine Aktuatorlage aus einem Aktuatormaterial aufweist. Vorzugsweise ist die schwingfähige Membran derart strukturiert, dass sie eine Mäanderstruktur umfassend vertikale und horizontale Abschnitte aufweist.

Eine Mäanderstruktur bezeichnet bevorzugt eine aus einer Abfolge zueinander im Wesentlichen orthogonaler Abschnitte im Querschnitt gebildete Struktur. Bei den zueinander orthogonalen Abschnitten handelt es sich bevorzugt um vertikale und horizontale Abschnitte der schwingfähigen Membran. Besonders bevorzugt ist die Mäanderstruktur im Querschnitt rechteckig. Es kann aber auch bevorzugt sein, dass die Mäanderstruktur im Querschnitt eine Sägezahnform (Zick-Zack-Form) aufweist oder kurvenförmig bzw. wellenförmig ausgestaltet ist. Dies ist insbesondere der Fall, sofern die vertikalen Abschnitte nicht exakt parallel mit der vertikalen Emissions- oder Detektionsrichtung ausgerichtet vorliegen, sondern einen Winkel beispielsweise von ± 30°, bevorzugt ± 20°, besonders bevorzugt ± 10° mit der vertikalen Richtung einschließen.

Die horizontalen Abschnitte können in bevorzugten Ausführungsformen ebenfalls nicht exakt unter einem orthogonalen Winkel von 90° zur vertikalen Emissions- oder Detektionsrichtung stehen, sondern beispielsweise einen Winkel zwischen 60° und 120°, bevorzugt zwischen 70° und 110°, besonders bevorzugt zwischen 80° und 100° mit der vertikalen Richtung einschließen.

Vorzugsweise sind die vertikalen und/oder horizontalen Abschnitte mindestens abschnittsweise oder über deren gesamte Länge geradlinig, die vertikalen und/oder horizontalen Abschnitte können jedoch auch mindestens abschnittsweise oder über deren gesamte Länge kurvig ausgestaltet sein. Im Falle einer kurvenförmigen bzw. welligen Form der vertikalen und/oder horizontalen Abschnitte der schwingfähigen Membran im Querschnitt bezieht sich die Ausrichtung bevorzugt auf eine Tangente an die vertikalen und/oder horizontalen Abschnitte an deren jeweiligen Mittelpunkten.

Während die schwingfähige Membran bevorzugt horizontal zur Schallemissionsrichtung oder Schalldetektionsrichtung ausgerichtet vorliegt, werden die Schallwellen durch eine Aktuierung der vertikalen Abschnitte erzeugt oder umgekehrt detektiert.

Bevorzugt dient die Lage aus einem Aktuatormaterial in den vertikalen Abschnitten als Bestandteil eines mechanischen Biomorphs, wobei durch Ansteuerung derAktuatorlage über die Elektrode eine laterale Wölbung der vertikalen Abschnitte bewirkt wird oder wobei durch eine induzierte laterale Wölbung ein entsprechendes elektrisches Signal erzeugt wird. Ein Bimorph bezeichnet bevorzugt eine Struktur, die zwei Schichten umfasst, wobei durch eine Zusammenwirkung der beiden Schichten eine Verschiebung und/oder Wölbung ermöglicht wird.

In einer bevorzugten Ausführungsform weisen die vertikale Abschnitte mindestens zwei Lagen auf, wobei eine Lage ein Aktuatormaterial und eine zweite Lage ein mechanisches Stützmaterial umfasst und wobei mindestens die Lage umfassend das Aktuatormaterial und mit einer endseitigen Elektrode kontaktiert vorliegt, sodass die horizontalen Schwingungen durch eine Formänderung des Aktuatormaterials gegenüber dem mechanischen Stützmaterial erzeugbar sind. Damit liegt in der genannten bevorzugten Ausführungsform ein vertikaler Abschnitt als ein mechanischer Bimorph vor. In der Ausführungsform wird der mechanische Bimorph durch eine Lage aus Aktuatormaterial (z. B. einem piezoelektrischen Material) und einer passiven Lage gebildet, welche als mechanische Stützschicht fungiert. Beim mechanischen Bimorph liegt das Aktuatormaterial bevorzugt bereits als Aktuatorlage vor.

Durch die Bereitstellung derAktuatorlage durch eine Ausrichtung und/oder Verstreckung der Polymere des Aktuatormaterials lassen sich vorteilhafterweise die piezoelektrischen Eigenschaften besonders gut einstellen. Durch eine höhere Verstreckung und/oder Ausrichtung des Aktuatormaterials kann beispielsweise ein höherer Abstand von Partialladungen von Atomen und/oder Molekülen der Polymere des Aktuatormaterials generiert werden. Hierdurch wird das Dipolmoment erhöht, sodass die piezoelektrischen Eigenschaften verstärkt werden. Umgekehrt kann durch eine geringere Verstreckung und/oder Ausrichtung des Aktuatormaterials der Abstand von Partialladungen von Atomen und/oder Molekülen der Polymere des Aktuatormaterials verringert eingestellt werden. Hierdurch wird das Dipolmoment weniger stark erhöht, sodass die piezoelektrischen Eigenschaften weniger ausgeprägt sind. Durch entsprechende Verstreckung und/oder Ausrichtung des Aktuatormaterials lässt sich vorteilhaft die Sensitivität derAktuatorlage im Kontext der Verwendung als Bimorph präzise einstellen. Eine Einstellung der Ausrichtung und/oder Verstreckung der Polymere des Aktuatormaterials und mithin der piezoelektrischen Eigenschaften lässt sich beispielsweise durch eine Wahl von Verstreckungsfaktoren vornehmen, die im weiteren Verlauf noch näher beschrieben werden.

Für die Biegung des Bimorphs kann sowohl ein transversaler als auch longitudinaler Piezoeffekt genutzt werden. Beim direkten longitudinalen Piezoeffekt erfolgt die Krafteinwirkung und damit der resultierende Stressgradient durch die Druckwellen entlang polarer Achsen. Beim inversen longitudinalen Piezoeffekt erfolgt die Anlegung der Spannung entlang einer nicht-polaren Achse, was zur Ausdehnung der Elementarzelle entlang einer polaren Achse derAktuatorlage führt. Eine polare Achse meint bevorzugt eine Achse, die zwischen zwei Ladungsschwerpunkten verläuft, bevorzugt zwischen zwei ungleichnamigen Ladungsschwerpunkten. Beim direkten transversalen Piezoeffekt erfolgt die Krafteinwirkung entlang einer nicht-polaren Achse durch aufkommende Druckwellen, sodass ein elektrisches Signal an der Elektrode gemessen werden kann. Mit der nicht-polaren Achse ist bevorzugt eine Achse gemeint, die nicht entlang zweier Ladungsschwerpunkte verläuft. Beim inversen transversalen Piezoeffekt erfolgt die Anlegung der Spannung entlang einer polaren Achse, was zur Ausdehnung der Elementarzelle entlang einer nicht-polaren Achse derAktuatorlage führt. Mithilfe einer C-Achsen Orientierung derAktuatorlage kann vorteilhaft ein transversaler Piezoeffekt genutzt werden.

Bei Ansteuerung derAktuatorlage kann diese beispielsweise eine transversale oder longitudinale Streckung oder Stauchung erfahren. Gegenüber der mechanischen Stützschicht wird hierdurch ein Stressgradient erzeugt, welcher zu einer lateralen Wölbung bzw. Schwingung führt. Durch wechselnde Polung an den Elektroden kann bevorzugt ein push-pull-Betrieb erfolgen, wodurch abwechselnd nahezu das gesamte Luftvolumen zwischen den vertikalen Abschnitten in vertikaler Emissionsrichtung bewegt werden kann. Durch die Verstreckung und/oder Ausrichtung der Polymere des Aktuatormaterials und der damit verbundenen Vergrößerung des Dipolmomentes und Verstärkung der piezoelektrischen Eigenschaften der Aktuatorlage ist eine besonders hohe Leistungsfähigkeit gegeben. Insbesondere kann die Leistungsfähigkeit bei einem push-pull-Betrieb je nach Anwendungsfall während der Herstellung präzise eingestellt werden. Vorteilhaft an dem Aktuatorprinzip ist somit eine hoch effiziente Übersetzung der horizontalen Schwingungen vertikaler Abschnitte in eine vertikale Volumenbewegung bzw. Schallerzeugung.

Da das Aktuatorprinzip nicht auf einer elektrostatischen Anziehung basiert, sondern auf einer relativen Formänderung (z.B. Stauchung, Streckung, Scherung) derAktuatorlage gegenüber einer Stützschicht, kann ein Verkleben der Membranabschnitte ausgeschlossen werden. Stattdessen können sich die vertikalen Abschnitte endlich berühren und sind somit in ihrer Auslenkung nicht eingeschränkt.

In einer weiteren bevorzugten Ausführungsform umfassen die vertikalen Abschnitte mindestens zwei Lagen, wobei beide Lagen ein Aktuatormaterial umfassen und mit Elektroden vorzugsweise endseitig kontaktiert vorliegen und die horizontalen Schwingungen durch eine Formänderung der einen Lage gegenüber der anderen Lage erzeugbar sind. In der Ausführungsform wird die horizontale Schwingung der vertikalen Abschnitte mithin nicht durch einen Stressgradienten zwischen einer aktiven Aktuatorlage und einer passiven Stützschicht generiert, sondern durch eine relative Formänderung zweier aktiver Aktuatorlagen. Auch in dieser Ausführungsform liegt mithin ein vertikaler Abschnitt als Bimorph vor.

Die Aktuatorlagen können hierbei aus demselben Aktuatormaterial bestehen und unterschiedlich angesteuert werden. Auch können die Aktuatorlagen aus unterschiedlichen Aktuatormaterialien bestehen, beispielsweise aus piezoelektrischen Materialien mit unterschiedlichem Deformationskoeffizienten. Die Aktuatorlagen werden vorzugsweise wie beschrieben mittels einer Verstreckung und/oder Ausrichtung der Polymere eines Aktuatormaterials gebildet, wobei das Ausmaß der Verstreckung und/oder Ausrichtung vorteilhaft auch zu Einstellung der Deformationskoeffizienten genutzt werden kann. Mit Deformationskoeffienten sind bevorzugt Materialgrößen gemeint, die zur Quantifizierung einer Auslenkung und/oder Schwingfähigkeit genutzt werden können. So können beispielsweise zwei unterschiedliche Aktuatormaterialien bereitgestellt werden, die gemeinsam eine Ausrichtung und/oder Verstreckung ihrer unterschiedlichen Polymere erfahren. Folglich können durch eine Ausrichtung und/oder Verstreckung der Polymere der beiden Aktuatormaterialien unterschiedliche Deformationskoeffizienten genutzt werden, um die Auslenkbarkeit der vertikalen Abschnitte zu regulieren.

Im Sinne der Erfindung wird die "Lage umfassend ein Aktuatormaterial" bevorzugt auch als Aktuatorlage bezeichnet.

Im Sinne der Erfindung wird die "Lage umfassend ein mechanische Stützmaterial" bevorzugt auch als Stützlage oder Stützschicht bezeichnet. Das mechanische Stützmaterial bzw. die Stützlage dient bevorzugt als passive Lage, welche einer Formänderung der Aktuatorlage widerstehen kann. Im Gegensatz zu einer Aktuatorlage ändert das mechanische Stützmaterial beim Anlegen einer elektrischen Spannung bevorzugt seine Form nicht. Bevorzugt ist das mechanische Stützmaterial elektrisch leitend, sodass es auch unmittelbar für eine Kontaktierung der Aktuatorlage verwandt werden kann. Es kann aber auch in einigen Ausführungsformen nichtleitend sein und beispielsweise mit einer elektrisch leitfähigen Lage beschichtet vorliegen.

Besonders bevorzugt handelt es sich bei dem mechanischen Stützmaterial um monokristallines Silizium, ein Polysilizium oder ein dotiertes Polysilizium.

Während die Aktuatorlage bei einer elektrischen Spannung eine Formänderung erfährt, verbleibt die Lage des mechanischen Stützmaterials im Wesentlichen unverändert. Der resultierende Stressgradient zwischen beiden Lagen (mechanischer Bimorph) bewirkt bevorzugt eine horizontale Wölbung. Zu diesem Zweck ist die Dicke der Stützlage im Vergleich zur Dicke der Aktuatorlage bevorzugt so zu wählen, dass für die Wölbung ein hinreichend großer Stressgradient generiert wird.

Die Mäanderstruktur entspricht bevorzugt einer entlang der Breite gefalteten Membran. Im Sinne der Erfindung kann eine schwingfähige Membran daher bevorzugt auch als Faltenbalg bezeichnet werden. Die parallelen Falten des Faltenbalges bilden bevorzugt die vertikalen Abschnitte. Die Verbindungsabschnitte zwischen den Falten bilden bevorzugt die horizontalen Abschnitte. Bevorzugt sind die vertikalen Abschnitte länger als die horizontalen Abschnitte, beispielsweise um einen Faktor 1,5, 2, 3, 4 oder mehr. Die horizontalen Abschnitte bezeichnen bevorzugt diejenigen Strukturen, die eine Verbindungen zwischen zwei oder mehr vertikalen Abschnitten ermöglichen.

Die Performance des MEMS-Wandlers, insbesondere eines MEMS-Lautsprechers oder MEMS-Mikrofons, kann wesentlich von der Anzahl und/oder Dimensionierung der vertikalen Abschnitte bestimmt werden.

In bevorzugten Ausführungsformen umfasst die schwingfähige Membran mehr als 3, 4, 5, 10, 15, 20, 30, 40, 50, 100 oder mehr vertikale Abschnitte.

In weiteren bevorzugten Ausführungsformen umfasst die schwingfähige Membran weniger als 10000, 5000, 2000 oder 1000 oder weniger vertikale Abschnitte.

Die bevorzugte Anzahl von vertikalen Abschnitten führt zu hohen Schallleistungen auf kleinsten Chip-Oberflächen, ohne dass das Klangbild oder die Audioqualität leidet.

Bevorzugt sind die vertikalen Abschnitte flächig, das bedeutet insbesondere, dass ihre Ausdehnung in jede der zwei Dimensionen (Höhe, Breite) ihrer Fläche größer ist als in einer hierzu senkrechten Dimension (der Dicke). Beispielsweise können Größenverhältnisse von mindestens 2:1, bevorzugt mindestens 5: 1, 10: 1 oder mehr bevorzugt sein.

Im Sinne der Erfindung entspricht die Höhe der vertikalen Abschnitte bevorzugt der Dimension entlang der Richtung der Schallemission oder Schalldetektion, während die Dicke der vertikalen Abschnitte bevorzugt die Summe der Schichtdicke der einen oder mehreren Lagen entspricht, welche die vertikalen Abschnitte bilden. Die Länge der vertikalen Abschnitte entspricht bevorzugt einer zur Höhe bzw. Dicke orthogonalen Dimension. In den Querschnittsansichten der unten aufgeführten Abbildungen sind Höhe und Dicke schematisch (nicht zwangsläufig skalengetreu) dargestellt, während die Dimension der Länge einer (nicht sichtbaren) Zeichnungstiefe der Abbildungen entspricht.

In einer bevorzugten Ausführungsform beträgt die Höhe der vertikalen Abschnitte zwischen 1 µm und 1000 µm, bevorzugt zwischen 10 µm und 500 µm. Auch Zwischenbereiche aus den vorgenannten Bereichen können bevorzugt sein, wie beispielsweise 1 µm bis 10 µm, 10 µm bis 50 µm, 50 µm bis 100 µm, 100 µm bis 200 µm, 200 µm bis 300 µm, 300 µm bis 400 µm, 400 µm bis 500 µm, 600 µm bis 700 µm, 700 µm bis 800 µm, 800 µm bis 900 µm oder auch 900 µm bis 1000 µm. Ein Fachmann erkennt, dass die vorgenannten Bereichsgrenzen auch kombiniert werden können, um weitere bevorzugte Bereich zu erhalten, wie beispielsweise 10 µm bis 200 µm, 50 µm bis 300 µm oder auch 100 µm bis 600 µm.

In einer bevorzugten Ausführungsform beträgt die Dicke der vertikalen Abschnitte zwischen 100 nm und 10 µm, bevorzugt zwischen 500 nm und 5 µm. Auch Zwischenbereiche aus den vorgenannten Bereichen können bevorzugt seien wie beispielsweise 100 nm bis 500 nm, 500 nm bis 1 µm, 1 µm bis 1,5 µm, 1,5 µm bis 2 µm, 2 µm bis 3 µm, 3 µm bis 4 µm, 4 µm bis 5 µm, 5 µm bis 6 µm, 6 µm bis 7 µm, 7 µm bis 8 µm, 8 µm bis 9 µm oder auch 9 µm bis 10 µm. Ein Fachmann erkennt, dass die vorgenannten Bereichsgrenzen auch kombiniert werden können, um weitere bevorzugte Bereich zu erhalten, wie beispielsweise 500 nm bis 3 µm, 1 µm bis 5 µm oder auch 1500 nm bis 6 µm.

In einer bevorzugten Ausführungsform beträgt die Länge der vertikalen Abschnitte zwischen 10 µm und 10 mm, bevorzugt zwischen 100 µm und 1 mm. Auch Zwischenbereiche aus den vorgenannten Bereichen können bevorzugt seien wie beispielsweise 10 µm bis 100 µm, 100 µm bis 200 µm, 200 µm bis 300 µm, 300 µm bis 400 µm, 400 µm bis 500 µm, 500 µm bis 1000 µm, 1 mm bis 2 mm, 3 mm bis 4 mm, 4 mm bis 5 mm, 5 mm bis 8 mm oder auch 8 mm bis 10 mm. Ein Fachmann erkennt, dass die vorgenannten Bereichsgrenzen auch kombiniert werden können, um weitere bevorzugte Bereich zu erhalten, wie beispielsweise 10 µm bis 500 µm, 500 µm bis 5 µm oder auch 1 mm bis 5 mm.

Mit den vorgenannten bevorzugten Dimensionierungen der schwingfähigen Membran bzw. der vertikalen Abschnitte kann ein besonders kompakter MEMS-Wandler, insbesondere MEMS-Lautsprecher oder MEMS-Mikrofon bereitgestellt werden, welcher gleichzeitig eine hohe Leistungsfähigkeit mit ausgezeichnetem Klangbild oder Audioqualität verbindet. Vorteilhaft können die genannten Maße besonders einfach durch eine entsprechende Ausgestaltung der Formgebungskomponente erlangt werden. Vorzugsweise bestimmt die Struktur der Formgebungskomponente die Struktur der schwingfähigen Membran umfassend vertikalen und horizontalen Abschnitten.

Die Richtungsangaben vertikal und horizontal (bzw. lateral) beziehen sich bevorzugt auf eine Vorzugsrichtung, in welcher die schwingfähige Membran zur Erzeugung oder Aufnahme von Druckwellen des Fluids ausgerichtet ist. Bevorzugt ist die schwingfähige Membran horizontal zwischen mindestens zwei Seitenbereichen eines Trägers aufgehangen, während die vertikale Richtung (Interaktionsrichtung mit dem Fluid) zur Erzeugung oder Aufnahme von Druckwellen orthogonal dazu vorliegt. Im Falle eines MEMS-Lautsprechers entspricht die vertikale (Interaktions-)Richtung der vertikalen Schallemissionsrichtung des MEMS-Lautsprechers. Vertikal meint in dem Fall bevorzugt die Richtung der Schallemission, während horizontal eine dazu orthogonale Richtung meint. Im Falle eines MEMS-Mikrofons entspricht die vertikale (Interaktions-)Richtung der vertikalen Schalldetektionsrichtung des MEMS-Mikrofons. Vertikal meint in dem Fall bevorzugt die Richtung der Schalldetektion bzw. Aufnahme, während horizontal eine dazu orthogonale Richtung meint.

Der schwingfähigen Membran des MEMS-Wandlers ist eine besondere Bedeutung beizumessen, da erst durch horizontale Auslenkung der vertikalen Abschnitte durch Druckwellen ein Messsignal erzeugt oder aufgenommen werden können. Entsprechend ist die Materialauswahl für die Bereitstellung der schwingfähigen Membran relevant für die Performance des MEMS-Wandlers. Erfindungsgemäß wurde erkannt, dass ein Aktuatormaterial umfassend Polymere, welches durch eine Ausrichtung und/oder Verstreckung eine Erhöhung des Dipolmomentes des Polymere bewirkt, besonders gute Ergebnisse liefert.

In einer weiteren bevorzugten Ausführungsform ist das Aktuatormaterial ausgewählt aus einer Gruppe umfassend ein piezoelektrisches Material, ein piezoelektrisches Polymermaterial und/oder elektroaktive Polymere (EAP), wobei bevorzugt das Aktuatormaterial ein piezoelektrisches Polymermaterial ist, wobei besonders bevorzugt das piezoelektrische Polymermaterial ausgewählt ist aus einer Gruppe umfassend Polyvinylidenfluorid (PVDF), Polyvinylidenfluorid-Co-Trifluorethylen) (PVDF-TrFE) und/oder Poly-L-Milchsäure (PLLA).

Ein Aktuatormaterial meint bevorzugt ein Material, welches unter Anlegung einer elektrischen Spannung eine Formänderung, beispielsweise eine Dehnung, Stauchung oder Scherung erfährt oder umgekehrt unter Formänderung eine elektrische Spannung erzeugt.

Bevorzugt sind Materialien mit elektrischen Dipolen, welche durch das Anlegen einer elektrischen Spannung eine Formänderung erfahren, wobei die Orientierung der Dipole und/oder des elektrischen Feldes die Vorzugsrichtung der Formänderungen bestimmen kann.

Bevorzugt kann das Aktuatormaterial ein piezoelektrisches Material, ein piezoelektrisches Polymermaterial (auch Piezoelectrical Material) und/oder elektroaktive Polymere (EAP) sein.

Zu den piezoelekrtischen Polymermaterialien gehören bevorzugt Polymere, welche interne Dipole und hierdurch vermittelt piezoelektrische Eigenschaften aufweisen. D. h. bei Anlegen einer äußeren elektrischen Spannung erfahren die piezoelektrischen Polymermaterialien (analog zu den vorgenannten klassischen piezoelektrischen Materialien) eine Formänderung (z.B Stauchung, Streckung oder Scherung). Ein Beispiel für ein bevorzugtes piezoelektrisches Polymermaterial ist Polyvinylidenfluorid (PVDF).

Elektroaktive Polymere (EAP) bezeichnen Polymere, die durch das Anlegen einer elektrischen Spannung ihre Form ändern. Üblicherweise werden zwischen ionischen EAP und elektronischen EAP unterschieden.Bei ionischen EAP beruht der Wirkungsmechanismus auf Massentransport (Diffusion) von Ionen. Untergruppen solcher EAP sind leitfähige Polymere, ionische Metall-Polymer-Komposite und ionische Gele. Die Wirkungsweise elektronischer EAP beruht hingegen auf elektronischem Ladungstransport. Zu dieser Gruppe werden elektrostriktive und ferroelektrische Polymere gezählt sowie dielektrische Elastomere.

Bevorzugt wird als Aktuatormaterial ein piezoelektrisches Polymermaterial eingesetzt, wobei besonders bevorzugt das piezoelektrische Polymermaterial ausgewählt ist aus einer Gruppe umfassend Polyvinylidenfluorid (PVDF), Polyvinylidenfluorid-Co-Trifluorethylen) (PVDF-TrFE) und/oder Poly-L-Milchsäure (PLLA). Die genannten Materialien haben sich vorteilhaft erwiesen, um einfach prozessiert zu werden und durch eine Ausrichtung und/oder Verstreckung gewünschte piezoelektrische Eigenschaften zu generieren.

Piezoelektrische Polymermaterialien sind vorteilhaft besonders einfach zu verformen, d. h. besonders handlich in ihrer Verarbeitung, weisen vorteilhaft eine niedrige Dielektrizitätszahl auf und eignen sich besonders gut für die Bereitstellung und Funktionstauglichkeit der schwingfähigen Membran.

Insbesondere sind diejenigen piezoelektrischen Polymermaterialien geeignet, die ein Dipolmoment im Wesentlichen senkrecht zur Hauptkette aufweisen. Dieses Phänomen ist besonders deutlich bei fluorierten Polymeren, wie z. B. PVDF zu beobachten, bei dem zwei Fluoratome an jedes zweite Kohlenstoffatom entlang der Vinylkette gebunden sind. Durch eine Ausrichtung und/oder Verstreckung können die Fluoratome derart angeordnet werden, dass ein Dipol entsteht, wodurch das Dipolmoment und damit auch die piezoelektrischen Eigenschaften erhöht werden. Fluor weist eine hohe Elektronegativität auf, während Wasserstoff eine deutliche geringere Elektronegativität aufweist. Durch die Ausrichtung der Fluor- und Wasserstoffatome entsprechend der β-Phase unter Berücksichtigung der Elektronegativitäten der Atomsorten wird vorteilhaft eine besonders starkes Dipolmoment erzeugt wird und damit eine Verstärkung der piezoelektrischen Eigenschaften bewirkt.

Eine besondere Bedeutung für die Erhöhung des Dipolmomentes kann hierbei eine Überführung des Aktuatormaterial in eine sogenannte β-Phase erlangen. Die β-Phase zeichnet sich bevorzugt durch eine all-trans planare Zickzack-Konformation der Atome aus, die ein erhebliches Dipolmoment hervorrufen (auch als TTTT-Konfiguration oder-Konformation bekannt). Im Falle von PVDF ist die β-Phase dadurch gekennzeichnet, dass die meisten der Fluoratome von den Wasserstoffatomen getrennt werden und ein Dipolmoment senkrecht zur Hauptkette erzeugt wird. Dadurch, dass Wasserstoff und Fluor unterschiedliche Elektronegativitäten aufweisen, wird ein starker Dipol erzeugt, welcher dementsprechend verstärkte piezoelektrische Eigenschaften aufweist. Insbesondere bei PVDF sind die CH₂-CF₂-Dipole streng senkrecht zur Kettenachse (Kohlenstoffkette) ausgerichtet. Die all-trans-Moleküle sind dabei im Wesentlichen parallel gepackt und bilden so eine kristalline Struktur, die β-Phase. Da Dipole in der β-Phase im Wesentlichen vollständig in einer Richtung ausgerichtet sind, liegt eine besonders ausgeprägte Polarisation vor, die sich durch Aufsummierung der CH₂-CF₂-Dipolmomente über eine Volumeneinheit ergibt.

Durch eine Ausrichtung und/oder Verstreckung der Polymere kann es bevorzugt zu einer Überführung des Aktuatormaterials, bevorzugt von PVDF, in eine β-Phase kommen. Bevorzugt lässt sich die β-Phase zuverlässig stabilisieren und/oder stärker ausprägen, um die piezoelektrischen Eigenschaften zu optimieren. Beim Einsatz von PVDF als piezoelektrisches Polymermaterial befindet sich dieses nach den bevorzugten Schritten zur Herstellung eines MEMS-Wandlers als Aktuatorlage in der β-Phase. Die Erfinder haben erkannt, dass sich die β-Phase von Aktuatormaterialien besonders gut eignet, um für eine verbesserte Leistungsfähigkeit von MEMS-Wandlern genutzt zu werden.

In einer bevorzugten Ausführungsform weist die Aktuatorlage eine relative Permittivität εᵣ von 1 - 15, bevorzugt von 5 - 15, besonders bevorzugt von 7 - 12 auf.

In einer bevorzugten Ausführungsform weist die Aktuatorlage piezoelektrische Ladungskoeffizienten von 1 - 50 pC/N (Pikocoulomb pro Newton), bevorzugt zwischen 1 - 5 pC/N, besonders bevorzugt von 5 - 30 pC/N, ganz besonders bevorzugt von 30 - 50 pC/N auf.

Die genannten Parameterbereiche hinsichtlich der relativen Permittivität und/oder der piezoelektrischen Ladungskoeffizienten betreffen bevorzugt die Aktuatorlage, d. h. die gebildete Lage des Aktuatormaterials nach einer Verstreckung und/oder Ausrichtung der Polymere. Die genannten Parameterbereiche führen insbesondere zu einer hohen Leistungsfähigkeit der Aktuatorlage und mithin verbesserten Funktionsfähigkeit des MEMS-Wandlers.

Mit der Verstreckung und/oder Ausrichtung der Polymere des Aktuatormaterials durch die Kontaktierung mit der Formgebungskomponente können vorteilhaft die genannten Parameterbereiche zuverlässig und wiederholbar erzielt werden. Bevorzugt führt die Verstreckung und/oder Ausrichtung der Polymere zu einer Verstärkung der piezoelektrischen Eigenschaften, wie z. B. bezogen auf den piezoelektrischen Ladungskoeffizienten, den piezoelektrischen Spannungskoeffizienten und den piezoelektrischen Kopplungskoeffizienten.

Der piezoelektrische Ladungskoeffizient setzt bevorzugt die pro Flächeneinheit erzeugte elektrische Ladung mit einer aufgebrachten mechanischen Kraft in Beziehung und wird in der Einheit Coulomb/Newton (C/N) ausgedrückt. Dieser Parameter wird häufig verwendet, um die Güte eines piezoelektrischen Materials zu bewerten.

Der piezoelektrische Spannungskoeffizient wird auch als Spannungsausgangskonstante bezeichnet. Er ist bevorzugt definiert als das Verhältnis zwischen dem erzeugten elektrischen Feld und der angelegten mechanischen Spannung und wird in der Einheit Spannungsmeter/Newton ausgedrückt.

Der piezoelektrische Kopplungskoeffizient (seltener als elektromechanischer Kopplungskoeffizient bezeichnet) ist bevorzugt definiert als das Verhältnis zwischen der mechanischen Energie, die als Reaktion auf einen elektrischen Eingang akkumuliert wird, und dem umgekehrten Verhältnis. Er entspricht auch dem Anteil der elektrischen Energie, der in mechanische Energie umgewandelt werden kann und umgekehrt.

Weiterhin ist es bevorzugt, dass Aktuatormaterial ein Elastizitätsmoduls aufweist zwischen ca. 1 - 5 GPa (Gigapascal), bevorzugt zwischen ca. 2 - 4 GPa, ganz besonders bevorzugt zwischen ca. 2 - 3 GPa. Die genannten Bereichen des Elastizitätsmodul haben sich vorteilhaft dahingehend bewährt, eine einfache Formgebung an die Formgebungskomponente zu schaffen, sodass die Mäanderstruktur mit hoher Präzision erlangt werden kann.

In einer weiteren bevorzugten Ausführungsform ist das Verfahren dadurch gekennzeichnet, dass das Aktuatormaterial in Form der Polymerfolie bereitgestellt wird, wobei mittels der Formgebungskomponente eine mechanische Streckung der Polymerfolie zur Ausbildung einer Aktuatorlage in die Mäanderstruktur umfassend die vertikale Abschnitte und die horizontalen Abschnitten ausgeführt wird.

Vorteilhaft lässt sich die Polymerfolie einfach prozessieren, insbesondere durch eine mechanische Streckung, um sie in die Mäanderstruktur umfassend den vertikalen und horizontalen Abschnitten zu führen. Dabei zeichnet sich die Polymerfolie durch eine Folie umfassend die Polymere aus, die nach der mechanischen Streckung der Polymerfolie ausgerichtet und/oder verstreckt vorliegen. Die Polymerfolie wird bevorzugt als ein Flächengebilde bereitgestellt. Ein Flächengebilde meint bevorzugt eine Struktur, deren Ausdehnung in einer Fläche (Länge oder Breite) um ein Vielfaches höher ist als orthogonal zur Fläche (Dicke). So kann die Länge oder Breite um einen Faktor von ca. 2, 3, 10, 20, 50, 100 oder mehr größer sein als die Dicke einer Polymerfolie.

In einer bevorzugten Ausführungsform beträgt die Dicke der Polymerfolie zwischen 100 nm und 50 µm, bevorzugt zwischen 500 nm und 10 µm. Auch Zwischenbereiche aus den vorgenannten Bereichen können bevorzugt sein, wie beispielsweise 100 nm bis 500 nm, 500 nm bis 1 µm, 1 µm bis 1,5 µm, 1,5 µm bis 2 µm, 2 µm bis 3 µm, 3 µm bis 4 µm, 4 µm bis 5 µm, 5 µm bis 6 µm, 6 µm bis 7 µm, 7 µm bis 8 µm, 8 µm bis 9 µm, 9 µm bis 10 µm, 10 µm bis 20 µm, 20 µm bis 30 µm, 30 µm bis 40 oder auch 40 µm bis 50 µm Ein Fachmann erkennt, dass die vorgenannten Bereichsgrenzen auch kombiniert werden können, um weitere bevorzugte Bereich zu erhalten, wie beispielsweise 500 nm bis 5 µm, 1 µm bis 20 µm oder auch 1500 nm bis 10 µm.

Die Polymerfolie lässt sich vorteilhaft besonders einfach, d. h. insbesondere durch einen geringfügigen mechanischen Widerstand, mechanisch verstrecken, um die Mäanderstruktur für die schwingfähige Membran zu erzeugen. Dabei passt sich vorteilhaft die Polymerfolie mit höchster Genauigkeit an die Form der Formgebungskomponente an, sodass präzise eine gewünschte Mäanderstruktur erhalten werden kann. Gleichzeitig ist die Polymerfolie vorteilhaft rissbeständig, sodass die Durchführungszuverlässigkeit während des bevorzugten Verfahrens gegeben ist. So weist die Polymerfolie bevorzugt eine hohe Zugfestigkeit auf, wobei diese von der konkreten Materialauswahl des Aktuatormaterials abhängen kann. Die Zugfestigkeit kann bevorzugt je nach Material zwischen 20 N/mm² und 300 N/mm², bevorzugt zwischen 50 N/mm² - 250 N/mm², besonders bevorzugt zwischen 100 N/mm² - 200 N/mm², ganz besonders bevorzugt zwischen 120 N/mm² - 180 N/mm² betragen.

Auch die eingesetzte Temperatur während einer mechanischen Verstreckung kann für die später resultierende schwingfähige Membran relevant sein. In bevorzugten Ausführungsform kann die beispielsweise eine Temperatur ober- oder unterhalb der Glasübergangstemperatur des verwendeten Materials gewählt werden. Im Sinne der Erfindung kann die Temperatur daher während der Verstreckung und/oder Ausrichtung des Aktuatormaterials ebenfalls als eine Faktor für die Orientierung der Polymerer (bzw. Verstreckungsfaktor) aufgefasst werden.

Eine mechanische Verstreckung meint bevorzugt eine derartige Verstreckung, dass durch mechanische Wirkprinzipien die Polymere des Aktuatormaterials ausgerichtet und/oder verstreckt werden, um das Dipolmoment der Polymere zu erhöhen und damit verstärkte piezoelektrische Eigenschaften zu generieren. Eine mechanische Verstreckung erfolgt bevorzugt, wenn eine Polymerfolie bereitgestellt wird. Unter einer mechanischen Verstreckung fällt beispielweise die Applizierung eines Niederdrucks, um die Polymerfolie in die Mäanderstruktur zu überführen. Ebenfalls fällt unter einer mechanischen Verstreckung bevorzugt eine Zusammenwirkung zweier Formgebungskomponenten, um die Mäanderstruktur der schwingfähigen Membran zu erhalten.

Mit einer Verstreckung der Polymerfolie wird bevorzugt eine Vergrößerung der Fläche und/oder einer Länge entlang einer Dimension erreicht. Eine Vergrößerung der Fläche und/oder Länge kann bevorzugt 10%, 20%, 30%, 40%, 50%, 60%, 70%, 80%, 90%, 100%, 200%, 300 %, 400% oder mehr in Bezug auf eine Ausgangsfläche und/oder Ausgangslänge betragen, wobei eine Vergrößerung um 100%, 200%, 300 %, 400% eine Vergrößerung um einen Faktor 2, 3, 4 meint. Insbesondere wird hierdurch erreicht, dass die Polymere der Aktuatormaterials entlang der vertikalen Richtung durch die mechanische Verstreckung verstreckt werden, um die piezoelektrischen Eigenschaften zu erhöhen.

Vorteilhaft gelingt es mit einer mechanische Verstreckung, dass die Aktuatorlage umfassend das Aktuatormaterial eine besonders präzise C-Achsen Orientierung erhält, welche senkrecht zur Oberfläche der vertikalen Abschnitte der resultierenden Mäanderstruktur vorliegt. Durch eine C-Achsen Orientierung kann beispielsweise ein transversaler Piezoeffekt (piezoelektrischer Effekt) genutzt werden für die Schwingung der vertikalen Abschnitte der resultierenden schwingfähigen Membran. Auch andere Orientierungen können bevorzugt vorliegen und beispielsweise die Ausnutzung eines longitudinalen Piezoeffekts zur Ausbildung der horizontalen Wölbungen bzw. Schwingungen betreffen.

In einer weiteren bevorzugten Ausführungsform ist das Verfahren dadurch gekennzeichnet, dass die Formgebungskomponente eine Kammstruktur umfassend Kammfinger aufweist.

Eine Kammstruktur ist bevorzugt eine Struktur, die mehrere Kammfinger aufweist, die bevorzugt regelmäßig angeordnet sind, d. h. insbesondere, dass die Kammfinger hinsichtlich Form, Länge, Breite und Dicke im Wesentlichen identisch sind. Die Kammstruktur umfasst bevorzugt auch Leerbereiche. Ein Leerbereich bezeichnet bevorzugt einen Bereich der Kammstruktur, an dem das Material der Kammstruktur nicht vorhanden ist. Bevorzugt umfasst eine Kammstruktur eine regelmäßige abwechselnde Folge von einem Kammfinger und einem Leerbereich.

Die Kammstruktur kann vorteilhaft durch gängige Methoden der Halbleiter- Mikrosystemtechnik bereitgestellt werden, beispielweise durch die Ätzung eines Substrats. Die geätzten Bereiche des Substrats werden als Leerbereiche bezeichnet, während die verbleibenden Bereiche die Kammfingern darstellen. Da die Bereitstellung der Kammstruktur vorteilhaft besonders einfach durchführbar ist, kann vorteilhafterweise die Mäanderstruktur, je nach Anwendungszweck, hinsichtlich der Ausgestaltung optimiert werden. So entspricht die Länge der Kammfinger bevorzugt der Länge der vertikalen Abschnitte, wobei eine Breite der Leerbereiche der Breite der horizontalen Abschnitte entspricht.

In einer weiteren bevorzugten Ausführungsform ist das Verfahren dadurch gekennzeichnet, dass die Formgebungskomponente eine Kammstruktur umfassend Kammfinger umfasst sowie die Kammstruktur Öffnungen aufweist, wobei das Aktuatormaterial als Polymerfolie auf die Kammfinger der Kammstruktur aufgebracht wird und ein Niederdruck, bevorzugt ein Vakuum, über die Öffnungen appliziert wird, sodass Teilbereiche der Polymerfolie in Richtung der Öffnungen mechanisch gestreckt werden, sodass eine Mäanderstruktur gebildet wird.

Bevorzugt sind die Öffnungen an einem Hauptstrang der Kammstruktur angebracht. Der Hauptstrang der Kammstruktur bezeichnet bevorzugt denjenigen Abschnitt, auf dem die Kammfinger angebracht sind. Die Öffnungen können durch bekannte Verfahren des Standes der Technik angebracht werden, beispielsweise durch bekannte Ätzverfahren. Bevorzugt werden die Öffnungen derart in den Hauptstrang der Kammstruktur eingebracht, dass sie zwischen den Kammfingern positioniert sind. Durch die Applizierung eines Niederdrucks werden Bereiche der Polymerfolie in Richtung der Öffnungen, d. h. insbesondere in Richtung des Hauptstrangs der Kammstruktur, mechanisch gestreckt.

Bevorzugt wird die Polymerfolie an der Kammstruktur an ihren Endbereichen fixiert, sodass durch eine Fixierung der Polymerfolie nach der Applikation des Niederdruckes eine entsprechend gedehnte Polymerfolie resultiert. In diesem Fall erfolgt vorzugsweise eine Verstreckung der gesamten Polymerfolie entlang einer Dimension der hintereinander aufgereihten Kammfinger, wobei der Grad der Verstreckung bzw. Dehnung durch die Höhe und/oder Dauer des applizierten Niederdruckes eingestellt werden kann.

Durch eine Stärke einer endseitigen Fixierung kann zudem bevorzugt ein mechanischer Widerstand der Polymerfolie gegenüber der Applikation des Niederdrucks eingestellt werden, welche zu einer unterschiedlich stark ausgeprägten Verstreckung oder Dehnung der Polymerfolie führt. Im Falle einer endseitigen Fixierung, welche keine relative Bewegung der Polymerfolie zulässt, wird der Längenzuwachs der Polymerfolie durch Formung der vertikalen Abschnitte vollständig zur Dehnung der Polymerfolie beitragen. Bei einer weniger stark ausgeprägten endseitigen Fixierung kann es sein, dass eine Formung vertikaler Abschnitte durch Applikation eines Niederdruckes an den Öffnung nur teilweise aus einer Dehnung bzw. Verstreckung der Polymerfolie resultiert, da eine Zuführung von Polymerfolie von Bereichen außerhalb der Kammstruktur nicht vollständig unterbunden wird. Vorteilhaft kann durch die Einstellung der endseitigen Fixierung eine gewünschte Höhe der vertikalen Abschnitte sowie eine Verstreckung bzw. Dehnung der Polymerfolie unabhängig voneinander eingestellt werden.

In weiteren Ausführungsformen kann es auch bevorzugt sein, dass die Polymerfolie auf den Auflageflächen der Kammfinger fixiert vorliegt, sodass bei Applikation eines Niederdruckes diese Bereiche nicht verstreckt werden. Diejenigen Bereiche der Polymerfolie, die in Richtung der Öffnungen verstreckt werden, bilden nach der Verstreckung die vertikalen Abschnitte, während diejenigen Bereiche, die nicht verstreckt werden, die horizontalen Abschnitte bilden.

Die Applizierung eines Niederdrucks meint bevorzugt die Wirkung eines Drucks, der niedriger ist als der Druck, der zwischen den Kammfingern der Kammstruktur vorliegt. Besonders bevorzugt ist der Niederdruck ein Vakuum. Der Niederdruck kann bevorzugt niedriger sein als der Umgebungsdruck. Bevorzugt ist der Niederdruck ausgewählt aus einem Bereich umfassend ca. 0 - 100 000 Pa (Pascal), bevorzugt zwischen ca. 0 - 50 000 Pa, besonders bevorzugt zwischen ca. 0 - 20 000 Pa, ganz besonders bevorzugt zwischen ca. 0 - 10 000 Pa, besonders stark bevorzugt zwischen ca. 0 - 5000 Pa. Vorzugsweise kann der Niederdruck an die mechanischen Eigenschaften, z. B. an die Elastizität einer Polymerfolie, angepasst werden.

Der Niederdruck kann im erfindungsgemäßen Kontext als ein Verstreckungsfaktor aufgefasst werden. Durch die Höhe des Niederdrucks kann unter anderem die Verstreckung der Polymerfolie zur Bereitstellung der Aktuatorlage reguliert werden. Beispielsweise kann durch die Einstellung des Niederdrucks die Verstreckung als solche reguliert werden, da mit dem Wert und/oder der Wirkdauer des Niederdrucks die Höhe der resultierenden vertikalen Abschnitte (und im Falle einer endseitigen Fixierung eine Längendehnung der Polymerfolie) anpassbar ist. Somit kann auch die Wirkdauer, d. h. die Zeit, in der der Niederdruck wirkt, ebenfalls als Verstreckungsfaktor aufgefasst werden. Somit kann durch den Niederdruck die Form der schwingfähigen Membran vorteilhaft besonders einfach eingestellt werden.

Bevorzugt erfolgt das Applizieren eines Niederdrucks durch die Öffnungen der Kammstruktur bei einer Temperatur zwischen ca. 180°C - 220°C. Durch die eingesetzte Temperatur kann die Verstreckung der Polymerfolie in Richtung der Öffnungen begünstigt werden, sodass insbesondere eine schnellere Verstreckung in Richtung der Öffnungen ermöglicht wird. Dies liegt unter anderem daran, ohne auf die Theorie beschränkt zu sein, dass bei einer erhöhten Temperatur die mechanische Spannung der Polymerfolie verringert wird, wodurch eine Verstreckung mit verringertem mechanischen Widerstand durchführbar ist. Die Temperatur während der bevorzugten Applizierung des Niederdrucks stellt bevorzugt ebenfalls einen Verstreckungsfaktor dar.

Auch die Form der Kammstruktur, auf deren Kammfinger die Polymerfolie bevorzugt angebracht wird bei der Applizierung eines Niederdrucks, kann als Verstreckungsfaktor aufgefasst werden. Beispielsweise bestimmt die Höhe und Breite der Kammfinger ungefähr die Höhe der vertikalen Abschnitte und Breite der horizontalen Abschnitte der resultierenden schwingfähigen Membran, sofern ein Niederdruck appliziert wird, welche die Polymerfolie vollständig an die Kammstruktur anformt.

Bevorzugt wird über jede Öffnung ein im Wesentlichen identischer Niederdruck appliziert, um eine möglichst gleichförmige mechanische Verstreckung der Polymerfolie zu bewirken. Auf die mechanische Verstreckung durch den Einsatz eines Niederdrucks kann durch die Größe der Öffnungen und/oder dem Wert des Niederdruck Einfluss genommen werden. Je geringer der Druck und/oder desto größer die Öffnung, desto schneller erfolgt die mechanische Verstreckung der Polymerfolie, um die Mäanderstruktur bereitzustellen. Die Applikation eines Niederdruckes führt vorteilhaft zu einer besonders gleichmäßigen Verstreckung und mithin ausgezeichneten Ergebnissen hinsichtlich der Leistung und Klangperformance der gebildeten Aktuatorlagen. Auch werden d potentielle Schädigungen der Aktuatorlage wirksam vermieden.

In einer weiteren bevorzugten Ausführungsform ist das Verfahren dadurch gekennzeichnet, dass das Aktuatormaterial als Polymerfolie auf einer ersten Kammstruktur aufgebracht wird, wobei eine zweite Kammstruktur in Richtung der Polymerfolie geführt wird und jeweilige Kammfinger der ersten Kammstruktur und der zweiten Kammstruktur in Leerbereiche geführt werden, sodass in einer Zusammenwirkung des ersten Kammstruktursubstrates und des zweiten Kammstruktursubstrates die Mäanderstruktur umfassend die vertikale Abschnitte und die horizontale Abschnitte gebildet wird.

Bevorzugt wird die Polymerfolie derart auf die erste Kammstruktur aufgebracht, sodass die Polymerfolie entlang der Längsachse der Kammfinger anliegt. Durch die Zusammenwirkung der ersten Kammstruktur und der zweiten Kammstruktur wird die Mäanderstruktur bereitgestellt. Mit der Zusammenwirkung ist bevorzugt gemeint, dass die erste Kammstruktur und die zweite Kammstruktur derart aneinander geführt werden, dass die jeweiligen Längsachsen der Kammfinger in die Leerbereiche der anderen Kammstruktur eingeführt werden. Mithin resultiert durch die Einführung der Kammfinger der ersten Kammstruktur in die Leerbereiche der zweiten Kammstruktur eine Membran mit einer Mäanderstruktur umfassend vertikale und horizontale Abschnitte.

Bevorzugt werden die erste Kammstruktur und die zweite Kammstruktur derart aneinander geführt, dass die Kammfinger der beiden Kammstrukturen im Wesentlichen senkrecht zur vertikalen Richtung und einer horizontalen Richtung der daraufhin bereitgestellten Aktuatorlage bzw. schwingfähigen Membran vorliegen. Insbesondere werden die Kammfinger der beiden Kammstrukturen derart aneinander geführt, dass die Kammfinger in einer sagittalen Richtung orientiert sind.

Die Länge der vertikalen Abschnitte kann bevorzugt durch den finalen Abstand der ersten Kammstruktur zur zweiten Kammstruktur bestimmt werden. Der finale Abstand der ersten Kammstruktur und der zweiten Kammstruktur meint bevorzugt den Abstand, der vorliegt, nachdem die mechanische Verstreckung erfolgt ist. Umso größer der finale Abstand ist, umso länger ist der vertikale Abschnitt ausgestaltet. Vorzugsweise ist mit dem finalen Abstand zwischen der ersten Kammstruktur und der zweiten Kammstruktur der finale Abstand zwischen den Spitzen der Kammfinger gemeint. Damit ist auch der finale Abstand in dieser Ausführungsform ein Verstreckungsfaktor, mit dem die Form sowie Verstreckung der Aktuatorlage optimiert werden kann. Auch durch die Form der beiden Kammstrukturen, beispielsweise durch die Länge und/oder Breite, kann die Form sowie Verstreckung der Aktuatorlage und damit der schwingfähigen Membran reguliert werden, beispielsweise die Länge der vertikalen Abschnitte und/oder die Form in einer sagittalen Richtung.

Bevorzugt wird der finale Abstand zwischen der ersten Kammstruktur und der zweiten Kammstruktur durch einen Führungsweg der ersten Kammstruktur und der zweiten Kammstruktur bestimmt.

Bevorzugt wird die Polymerfolie an der ersten Kammstruktur an ihren Endbereichen fixiert, sodass durch eine Fixierung der Polymerfolie nach der Zusammenwirkung der ersten Kammstruktur mit der zweiten Kammstruktur die Mäanderstruktur der schwingfähigen Membran resultiert. Durch Stärke der Fixierung kann bevorzugt der mechanische Widerstand der Polymerfolie eingestellt werden, sodass bei einer besonders starken Fixierung ein höherer mechanischer Widerstand generierbar ist als bei einer schwächeren Fixierung. Somit ist vorzugsweise die Fixierung der Polymerfolie an den Endbereichen der ersten Kammstruktur ebenfalls ein Verstreckungsfaktor.

Durch eine Kombination der Wahl der Stärke der Fixierung der Polymerfolie an Endbereichen der ersten Kammstruktur und dem Führungsweg kann eine für die Form der Mäanderstruktur besonders genaue Einstellung vorgenommen werden. So lassen sich beispielsweise die Länge, die Breite, die Form und/oder die Steifigkeit der vertikalen und/oder horizontalen Abschnitte durch die Wahl der Stärke der Fixierung der Polymerfolie, der Form der Kammstruktur und/oder der Länge des Führungsweges optimieren.

Vorzugsweise liegt eine Temperatur unter 180°C vor, während eine mechanische Verstreckung durch ein Zusammenwirken der ersten und der zweiten Kammstruktur erfolgt. Je nach Höhe der Temperatur kann hierdurch auch die Verstreckung erleichtert werden, um durch die Temperaturwirkung die mechanische Spannung der Polymerfolie zu verringern. Die Temperatur während der Zusammenwirkung der ersten Kammstruktur mit der zweiten Kammstruktur kann hierbei ebenfalls als ein Verstreckungsfaktor angesehen werden.

In bevorzugten Ausführungsformen erfolgt die Verstreckung durch die Applizierung eines Niederdrucks oder durch das Zusammenwirkung der ersten Kammstruktur und der zweiten Kammstruktur bei einer Temperatur, die ober- oder unterhalb der Glasübergangstemperatur der Polymerfolie liegt. Durch Einstellung der Temperatur kann sowohl der Prozess der Formung der Mäanderstruktur als auch Verstreckung bzw. Orientierung der Polymere vorteilhaft beeinflusst werden.

Bei einer Temperatur oberhalb der Glasübergangstemperatur wird die Formbarkeit der Polymerfolie erhöht, sodass eine besonders stabile Mäanderstruktur der Membran erhalten werden kann. Bei einer Temperatur unterhalb Glasübergangstemperatur der Polymere kann hingegen vorteilhaft eine besonders ausgeprägte Ausrichtung der Polymere erzielt werden.

Die verwandte Temperatur während Formgebung der Polymerfolie ist damit ein weiterer relevanter Faktor, welcher für den Erhalt der Mäanderstruktur sowie der piezoelektrischen Eigenschaften der schwingfähigen Membran optimiert werden kann.

Verstreckungsfaktoren bezeichnen im erfindungsgemäßen Kontext Faktoren, mit denen die Verstreckung der Polymere des Aktuatormaterials reguliert werden können. Diese können je nach Ausführungsform unterschiedliche Faktoren bzw. Parameter sein. So gehören zu den Verstreckungsfaktoren beispielsweise der Niederdruck, die Form der Kammstruktur(en), die Fixierung der Polymerfolie an der Kammstruktur, der Führungsweg von Kammstrukturen, Temperaturen, die bei der Verstreckung und/oder Ausrichtung der Polymere eingesetzt werden usw.

In einer weiteren bevorzugten Ausführungsform ist das Verfahren dadurch gekennzeichnet, dass das Aktuatormaterial in Form der Polymerfolie bereitgestellt wird, auf welcher zusätzlich mindestens eine Lage umfassend ein mechanisches Stützmaterial und/oder ein leitfähiges Material aufgebracht vorliegt, wobei die Lage umfassend das mechanische Stützmaterial und/oder die Lage umfassend ein leitfähiges Material ebenfalls eine mechanische Streckung bei der Kontaktierung mit der Formgebungskomponente erfährt.

Vorteilhaft kann durch eine mechanische Verstreckung der Polymerfolie in Kombination mit einer Verstreckung der mechanischen Stützschicht auf weitere Prozessierungsschritte verzichtet werden, sodass eine schnellere Bereitstellung der Mäanderstruktur ermöglicht wird. So ist durch eine mechanische Verstreckung des mechanischen Stützmaterials kombiniert mit der Verstreckung der Polymerfolie nicht mehr notwendig, die Beschichtung eines mechanischen Stützmaterials vorzunehmen.

So kann es bevorzugt sein, die Polymerfolie zusammen mit einem mechanischen Stützmaterial bereitzustellen, wobei vorzugsweise die Polymerfolie und das mechanische Stützmaterial aufeinander angebracht sind, und die Polymerfolie und das mechanische Stützmaterial in Kombination auf die Kammfinger einer Kammstruktur angeordnet werden. Bevorzugt liegen Öffnungen am Hauptstrang der Kammstruktur vor, die beispielsweise durch Ätzverfahren gebildet werden können. Durch die Applizierung eines Niederdrucks, bevorzugt eines Vakuums, wird entsprechend die Polymerfolie in Kombination mit dem mechanischen Stützmaterial in Richtung des Hauptstrangs und damit der Öffnungen überführt. Insbesondere werden diejenigen Bereiche in Richtung des Hauptstrangs überführt, die über die Leerbereiche der Kammstruktur positioniert sind. An Bereichen, bei denen die Polymerfolie und das mechanische Stützmaterial auf den Kammfingern platziert sind, erfolgt entsprechend keine Verstreckung in Richtung des Hauptstrangs bzw. der Öffnungen. Mithin kann eine Mäanderstruktur bereitgestellt werden, die die Polymerfolie und das mechanische Stützmaterial gemeinsam verstreckt.

Die mechanische Verstreckung der Polymerfolie in Kombination mit dem mechanischen Stützmaterial kann vorzugsweise auch durch den Einsatz einer ersten und zweiten Kammstruktur erfolgen. Die Polymerfolie und das mechanische Stützmaterial können bevorzugt aufeinander angeordnet bereitgestellt werden und derart auf die erste Kammstruktur angeordnet werden, dass sie entlang der Längsachse der Kammfinger angebracht werden. Bevorzugt wird die Mäanderstruktur durch eine Zusammenwirkung der ersten Kammstruktur sowie der zweiten Kammstruktur bereitgestellt. Bevorzugt werden die erste Kammstruktur und die zweite Kammstruktur derart gegeneinander geführt, dass die Kammfinger entsprechend in die Leerbereiche der anderen Kammstruktur gebracht werden. Mithin kann durch die Zusammenwirkung der ersten Kammstruktur mit der zweiten Kammstruktur die Mäanderstruktur sowohl für die Aktuatorlage als auch für die mechanische Stützlage bereitgestellt werden. Ebenfalls kann es bevorzugt sein, zunächst die Mäanderstruktur für die Polymerfolie bereitzustellen, um eine Aktuatorlage zu bilden und daraufhin das mechanische Stützmaterial zu beschichten.

In bevorzugten Ausführungsformen liegt leitfähiges Material aufgebracht auf und/oder unterhalb des Aktuatormaterials vor. Durch das Verstrecken und/oder Ausrichtung des Aktuatormaterials in Kombination mit dem leitfähigen Material kann vorteilhaft nach der Verstreckung zusätzlich zur Aktuatorlage eine Top- (auf dem Aktuatormaterial) und/oder Bottom-Elektrode (unterhalb des Aktuatormaterials) bereitgestellt werden.

In weiteren bevorzugten Ausführungsformen kann ein leitfähiges Material identisch sein mit dem Stützmaterial, sodass beispielsweise eine Bottom- und/oder Top-Elektrode zeitgleich eine mechanische Stützlage ist.

Die bevorzugte zusätzliche Aufbringung mindestens einer weiteren Lage umfassend ein mechanisches Stützmaterial und/oder ein leitfähiges Material auf der Polymerfolie, welche gemeinsam eine mechanische Streckung bei der Kontaktierung mit der Formgebungskomponente erfährt, ist insbesondere dann bevorzugt, wenn die mindestens eine weitere Lage dehnbar ist, d. h. mechanisch verformbar ohne Beschädigungen oder Risse zu erlangen. Ein dehnbares elektrisch leitfähiges Material kann bevorzugt ein Lack sein, der beispielsweise Kohlenstoffnanoröhrchen aufweist. Weist die mindestens eine weitere Lage umfassend ein mechanisches Stützmaterial und/oder ein leitfähiges Material keine hinreichende Dehnbarkeit für die mechanische Verstreckung auf, ist es bevorzugt, dass erst nach der Formausgestaltung der Polymerfolie die mindestens eine weitere Lage durch eine Beschichtung aufgetragen wird.

In einer weiteren bevorzugten Ausführungsform ist das Verfahren dadurch gekennzeichnet, dass nach einer mechanischen Streckung das Aktuatormaterial in Form der Polymerfolie zusätzlich mit mindestens einer Lage umfassend ein mechanisches Stützmaterial und/oder ein leitfähiges Material beschichtet wird. Hierdurch wird eine Stützlage und/oder einer Lage umfassend ein elektrisch leitfähiges Material erhalten, welches die Mäanderstruktur gemäß der verstreckten Polymerfolie aufweist, ohne dass das Stützmaterial oder das elektrisch leitfähige Material selbst verstreckt werden müsste.

Vorzugsweise erfolgt die die Aufbringung der mindestens einen Lage umfassend das mechanische Stützmaterial und/oder des leitfähigen Materials durch den Einsatz eines Beschichtungsverfahrens innerhalb einer Beschichtungsanlage. Das Beschichtungsverfahren kann beispielsweise ausgewählt sein aus einer Gruppe umfassend Sprühbeschichtung, Nebelbeschichtung und/oder Dampfbeschichtung. Die genannten Beschichtungsverfahren sind dem Fachmann bekannt und lassen sich vorteilhaft einfach ausführen.

Vorzugsweise erfolgt die Beschichtung innerhalb einer Beschichtungsanlage, die eine physikalische Beschichtungsanlage oder chemische Beschichtungsanlage, bevorzugt plasmagestützte chemische Beschichtungsanlage, Niederdruck-chemische und/oder Epitaxie-Beschichtungsanlage sein kann.

Vorzugsweise findet die Beschichtung innerhalb eines Temperaturbereiches statt, bei dem es nicht zu einer Veränderung der bereits ausgerichteten Polymere des Aktuatormaterials kommt, sodass die verstärkten piezoelektrischen Eigenschaften besonders zuverlässig erhalten bleiben.

Insbesondere ist es bevorzugt, dass sämtliche Schritte des Verfahrens zur Bereitstellung eines MEMS-Wandlers, welche nach einer Verstreckung/oder Ausrichtung der Polymere des Aktuatormaterials bei einer Temperatur erfolgen, bei welcher die verstärkten piezoelektrischen Eigenschaften der Aktuatorlage nicht kompromittiert werden. Besonders bevorzugt werden für Verfahrensschritte zur Bereitstellung eines MEMS-Wandlers nach einer Verstreckung/oder Ausrichtung der Polymere des Aktuatormaterials Temperaturen von mehr als 300°C, bevorzugt mehr als 200°C oder mehr als 150°C vermieden.

In einer weiteren bevorzugten Ausführungsform ist das Verfahren dadurch gekennzeichnet, dass die schwingfähige Membran eine Lage umfassend ein leitfähiges Material umfasst, welche als Top- und/oder als Bottom-Elektrode fungiert.

Die Top- und/oder Bottom-Elektrode meint bevorzugt eine Lage umfassend ein elektrisch leitfähiges Material, welches sich über die gesamte Fläche der schwingfähigen Membran erstreckt. Vorzugsweise ist die Lage mit einem Elektrodenpad als Elektrode kontaktiert, wobei bevorzugt das leitfähige Material in Kombination mit der Elektrode auch als Top- und/oder Bottom-Elektrode bezeichnet werden kann, wobei bevorzugt die Elektrode mit einer Elektronik zur Bereitstellung einer elektrischen Spannung und/oder eines elektrischen Stroms vorliegt. Vorzugsweise ist die Elektrode endseitig angebracht, sodass eine Aktuierung der Aktuatorlage ausgehend von der Elektrode möglich ist oder ein elektrisches Signal an der Elektrode ausgelesen werden kann durch eine entsprechende Formänderung der Aktuatorlage.

Besonders bevorzugt liegt die Lage aus einem leitfähigem Material, bevorzugt ein Metall, im Sinne einer Top- oder Bottomelektrode als eine durchgängige bzw. ganzflächige oder zusammenhängende Schicht der schwingfähigen Membran vor, welche eine im Wesentlichen homogene Fläche bildet. Die Bezeichnungen Top und Bottom betreffen bevorzugt die Lage des leitfähigen Materials, sodass in einem Querschnitt davon gesprochen werden kann, dass die Top-Elektrode ein leitfähiges Material oberhalb auf der Aktuatorlage umfasst und die Bottom-Elektrode ein leitfähiges Material unterhalb der Aktuatorlage.

Mittels der Lage aus einem leitfähigem Material, bevorzugt Metall, können vorteilhaft die zwei oder mehr vertikalen Abschnitte mit einer endseitigen Elektrode bzw. einem Elektrodenpad kontaktiert werden.

Endseitig meint bevorzugt eine Positionierung der mindestens eine Elektrode, sodass eine Kontaktierung an eine Strom- oder Spannungsquelle an einem Ende der schwingfähigen Membran erfolgen kann, bevorzugt an einem Ende, an welchem die Membran am Träger aufgehangen vorliegt.

In bevorzugten Ausführungsformen umfasst der herstellbare MEMS-Wandler zwei endseitige Elektroden. Bevorzugt kann die Kontaktierung mit einer Elektronik, z. B. einer Strom- oder Spannungsquelle, mit den Elektroden an gegenüberliegende Enden der schwingfähigen Membran erfolgen, zwischen welchen die zwei oder mehr vertikalen Abschnitte vorliegen, sodass mittels der endseitigen Elektroden die Aktuatorlage(n) in den vertikalen Abschnitten angesteuert werden können.

Die endseitige Bereitstellung der Elektroden grenzt sich somit bevorzugt von einer Kontaktierung ab, welche die jeweiligen vertikalen Abschnitte mit jeweiligen separaten Elektroden ansteuert bzw. im Falle eines MEMS-Mikrofons erzeugte elektrische Signale abgreift. Bevorzugt umfasst der MEMS-Wandler somit genau eine oder genau zwei Elektroden zur endseitigen Kontaktierung und keine weiteren Elektroden(pads) für eine Kontaktierung mittiger vertikaler Abschnitte.

Bevorzugt dient die Lage aus einem Aktuatormaterial in den vertikalen Abschnitten als Bestandteil eines mechanischen Biomorphs, wobei durch Ansteuerung derAktuatorlage über die Elektrode eine laterale Wölbung der vertikalen Abschnitte bewirkt wird oder wobei durch eine induzierte laterale Wölbung ein entsprechendes elektrisches Signal erzeugt wird.

In einer weiteren bevorzugten Ausführungsform ist das Verfahren dadurch gekennzeichnet, dass die schwingfähige Membran eine Lage umfassend ein leitfähiges Material umfasst, wobei das leitfähige Material ausgewählt ist aus einer Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit, Kupfer, wobei bevorzugt das leitfähige Material ein superelastisches Metall ist, wobei besonders bevorzugt das leitfähige Material eine Faserverstärkung aufweist, wobei für die Faserverstärkung das leitfähige Material Fasern aufweist, wobei ganz besonders bevorzugt die Fasern Kohlenstoff umfassen.

Die leitfähigen Materialien ausgewählt aus einer Gruppe einer Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit, Kupfer eignen sich besonders gut, um im Rahmen eines Beschichtungsverfahren auf die Aktuatorlage aufgebracht zu werden, insbesondere nachdem die Polymerfolie mechanisch verstreckt worden ist.

Leitfähige Materialien wie superelastisches Metall ist oder leitfähiges Material, welches eine Faserverstärkung aufweist, eignet sich vorteilhaft besonders gut, um in Kombination mit der Polymerfolie eine mechanische Verstreckung zu erfahren.

Superelastische Metalle bezeichnen bevorzugt Metalle, die zu den superelastischen Werkstoffen gehören und ein sogenanntes pseudoelastisches oder aus superelastisches Verhalten zeigen. Bei starker Beanspruchung können sie sich reversibel bis zu einer hohen Dehnung verformen. Diese "elastische" Verformung kann die Elastizität der Metalle bis zum zwanzigfachen übertreffen. Die Ursache dieses Verhaltens ist eine Phasenumwandlung innerhalb des Werkstoffes. Hierbei können verschiedene Metalllegierungen eingesetzt werden, z. B. Legierungen umfassend Kupfer, Zink und Aluminium oder Kupfer, Aluminium und Nickel oder Nickel und Titan.

Faserverstärkte Materialien, wie z. B. mit Fasern umfassend Kohlenstoff verstärkte Materialien, können sich vorteilhaft sowohl auf die Stützfunktion als auch die elektrische Leitfähigkeit auswirken. So kann vorteilhaft durch die Faserverstärkung ein höherer mechanischer Widerstand erzeugt werden, sodass der Stressgradient der erzeugt wir bei der Verformung eines vertikalen Abschnitts erhöht wird und gleichzeitig die elektrische Leitfähigkeit durch eine Auswahl der entsprechenden Kristallstruktur der Fasern, z. B. des Kohlenstoffs, erhöht werden kann.

In einer weiteren bevorzugten Ausführungsform ist das Verfahren dadurch gekennzeichnet, dass die schwingfähige Membran eine Lage umfassend eines mechanisches Stützmaterial umfasst, wobei das mechanisches Stützmaterial ausgewählt ist aus einer Gruppe umfassend monokristallines Silizium, polykristallines Silizium und/oder dotiertes polykristallines Silizium.

Die genannten Materialien haben sich als besonders vorteilhaft erwiesen, um als Stützlage zu fungieren. Weiterhin eignen sie sich besonders gut, um Rahmen eines Beschichtungsverfahren auf die Aktuatorlage, z. B. nach einer mechanischen Verstreckung, aufgebracht zu werden.

In einer weiteren bevorzugten Ausführungsform ist das Verfahren dadurch gekennzeichnet, dass das Aktuatormaterial als Polymerflüssigkeit bereitgestellt wird und die Formgebungskomponente in die Polymerflüssigkeit eingetaucht wird, wobei nach der Kontaktierung der Formgebungskomponente mit der Polymerflüssigkeit die Polymere des Aktuatormaterials eine derartige Ausrichtung erfahren, dass ein Dipolmoment der Polymere erhöht und piezoelektrische Eigenschaften des Aktuatormaterials verstärkt werden, wobei bevorzugt die Formgebungskomponente eine Kammstruktur umfassend Kammfinger umfasst.

Die Ausrichtung der Polymere der Polymerflüssigkeit erfolgt durch das Eintauchen der Formgebungskomponente in die Polymerflüssigkeit. In Vorzugsformen kann die Formgebungskomponente zu diesem Zweck mit einer Zwischenbeschichtung versehen werden, welche eine Ausrichtung der Polymere bewirkt. Ebenso kann es bevorzugt sein, dass die Formgebungskomponente aus einem Halbleitermaterial gebildet wird, wobei eine Kristallorientierung für eine Ausrichtung der anwachsenden Polymerschicht genutzt wird. Durch eine entsprechende Auswahl bzw. Gestaltung der Formgebungskomponente kann vorteilhaft eine gewünschte Ausrichtung der Polymere der Polymerflüssigkeit bewirkt und piezoelektrische Eigenschaften der entstehenden Aktuatorlage erhöht werden.

Vorzugsweise erfolgt das Eintauchen der Formgebungskomponente in die Polymerflüssigkeit bei einer Temperatur, die über der Glasübergangstemperatur der Polymerflüssigkeit liegt, sodass vorteilhaft die Ausrichtung der Polymere leichter bereitgestellt werden kann.

In einer weiteren bevorzugten Ausführungsform ist das Verfahren dadurch gekennzeichnet, dass nach einer Kontaktierung der Formgebungskomponente mit der Polymerflüssigkeit die Polymerflüssigkeit an der Formgebungskomponente haften bleibt und aushärtet zur Ausbildung der Aktuatorlage umfassend vertikale und horizontale Abschnitte, wobei bevorzugt nach der Ausbildung der Aktuatorlage, die Aktuatorlage mit einer Lage umfassend ein leitfähiges Material und/oder ein mechanisches Stützmaterial beschichtet wird.

Die Ausrichtung der Polymere der Polymerflüssigkeit kann insbesondere dann (im viskosen Zustand) erfolgen, wenn nach dem Eintauchen der Formgebungskomponente die Ausrichtung eingefroren bzw. erhalten wird.

In einer weiteren bevorzugten Ausführungsform ist das Verfahren dadurch gekennzeichnet, dass zumindest ein Teilabschnitt der Formgebungskomponente, bevorzugt ein Gesamtabschnitt, nach einer Kontaktierung mit dem Aktuatormaterial entfernt wird, bevorzugt durch ein Ätzverfahren und/oder durch eine thermische Behandlung.

Durch das Ätzverfahren und/oder die thermische Behandlung kann vorteilhaft die Freilegung der Mäanderstruktur umfassend vertikalen und horizontalen Abschnitten erfolgen, sodass die Schwingfähigkeit bereitgestellt wird.

Ein Ätzverfahren bezeichnet bevorzugt ein Verfahren zur Ätzung, d. h. zur Abtragung von Material, um die Formgebungskomponente zu entfernen. Vorzugsweise ist das Ätzverfahren ausgewählt aus einer Gruppe umfassend nasschemische Ätzverfahren und/oder Trockenätzverfahren, bevorzugt physikalische und/oder chemische Trockenätzverfahren, besonders bevorzugt durch reaktives lonenätzen und/oder reaktives lonentiefenätzen (Bosch-Prozess), oder durch eine Kombination der vorgenannten Ätzverfahren gebildet werden.

Die vorgenannten Ätzprozesse sind dem Fachmann bekannt und können entsprechend ausgewählt werden, um eine effiziente Entfernung der Formgebungskomponente zu gewährleisten.

Bevorzugt kann eine Entfernung der Formgebungskomponente auch durch eine thermische Behandlung erfolgen. Eine thermische Behandlung bezeichnet bevorzugt ein Verfahren, um durch die Entfernung der Formgebungskomponente durch eine Hitzewirkung zu entfernen. Die Wahl der Temperatur hängt von dem Material ab, welches die Formgebungskomponente umfasst.

Nach der Freilegung der Mäanderstruktur sowie der Bereitstellung der schwingfähigen Membran wird diese mit dem Träger kontaktiert. Bevorzugt wird die schwingfähige Membran endseitig mit dem Träger kontaktiert, sodass sich die Membran entlang einer horizontalen Richtung erstreckt.

In einer weiteren bevorzugten Ausführungsform ist das Verfahren dadurch gekennzeichnet, dass die Formgebungskomponente und/oder der Träger ein Material umfasst ausgewählt aus einer Gruppe umfassend monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und/oder Glas.

Diese Materialien sind in der Halbleiter- und/oder Mikrosystemherstellung einfach und kostengünstig zu bearbeiten und eignen sich für Anwendungen im großen Maßstab. Insbesondere kann der Träger und/oder das Gehäuse kann aufgrund der Materialien und/oder Herstellungsweisen flexibel hergestellt werden. Insbesondere ist bevorzugt eine Herstellung des MEMS-Wandlers umfassend eine schwingfähige Membran zusammen mit einem Träger in einem (Halbleiter-)prozess, bevorzugt auf einem Wafer möglich. Hierdurch wird die Herstellung weiter vereinfacht und verbilligt, sodass kostengünstig ein kompakter und robuster MEMS-Wandler hergestellt werden kann.

In einer bevorzugten Ausführungsform der Erfindung umfasst der Träger zwei Seitenbereiche, bevorzugt vier Seitenbereiche, zwischen denen die schwingfähige Membran in horizontaler Richtung angeordnet vorliegt.

Bei dem Träger handelt es sich bevorzugt um eine Rahmenstruktur, welche im Wesentlichen durch eine durchgehende äußere Umrandung in Form von Seitenwänden eines freibleibenden flächigen Bereichs gebildet wird. Die Rahmenstruktur ist dabei bevorzugt stabil und biegesteif. Bei einer eckigen Rahmenform (dreieckiger, viereckiger, sechseckig oder allgemein mehreckiger Umriss) werden die einzelnen Seitenbereiche, die die Rahmenstruktur bevorzugt im Wesentlichen bilden, insbesondere Seitenwände genannt. Die schwingfähige Membran wird bevorzugt von mindestens zwei Seitenwänden des Trägers gehalten.

Bevorzugt umfasst der Träger vier Seitenbereiche, vorzugsweise mit zusätzlichen Stirnflächen, die in der Regel parallel zum gezeichneten Querschnitt. Diese weiteren zwei Seitenwände spannen die Rahmstruktur auf.

Vorzugsweise kann der Träger durch die Formgebungskomponente bereitgestellt werden, beispielsweise in Ausführungsformen, in denen eine mechanische Verstreckung bevorzugt ist. So kann es bevorzugt sein, dass beispielsweise im Falle einer mechanischen Verstreckung durch die Zusammenwirkung von zwei Formgebungskomponenten das Gehäuse des MEMS-Wandlers bereitgestellt wird.

In einem weiteren Aspekt betrifft die Erfindung einen MEMS-Wandler zur Interaktion mit einem Volumenstrom eines Fluids herstellbar gemäß einem Verfahren nach einem oder mehreren der vorherigen Ansprüche.

Der durchschnittliche Fachmann erkennt, dass technische Merkmale, Definitionen und Vorteile bevorzugter Ausführungsformen des beschriebenen Verfahrens zur Herstellung eines MEMS-Wandlers auch für den MEMS-Wandler gelten und umgekehrt.

Es war überraschend, dass bevorzugte Verfahrensschritte zur Herstellung des MEMS-Wandlers zu einem MEMS-Wandler führten, der sich durch ausgezeichnete akustische, elektrische und mechanische Eigenschaften auszeichnet, insbesondere hinsichtlich der schwingfähigen Membran. So konnte die Form der Mäanderstruktur besonders präzise eingestellt werden, beispielsweise durch die Wahl von Verstreckungsfaktoren. Insbesondere kann vorteilhaft besonders einfach die Form der vertikalen und/oder horizontalen Abschnitte bestimmt werden. Die Auslenkbarkeit der vertikalen Abschnitte kann vorteilhaft durch die Verstreckung und/oder Ausrichtung der Polymere des Aktuatormaterials reguliert werden, sodass sich der hergestellte MEMS-Wandler in einer Vielzahl von Anwendungsfällen auf effiziente Weise nutzen lässt. Mithin wirken sich bevorzugte Ausführungsformen des Verfahrens auf strukturelle und damit auch auf funktionelle Eigenschaften des MEMS-Wandlers aus.

Vorteilhafterweise weist der MEMS-Wandler eine Aktuatorlage mit hervorragenden piezoelektrischen Eigenschaften auf, sodass insbesondere die schwingfähige Membran eine verbesserte Leistungsperformance aufweist. So können vorteilhaft höhere Auslenkungen der vertikalen Abschnitte erzielt werden, wenn Schalldruckwellen detektiert werden soll im Falle eines MEMS-Mikrofons oder Schalldruckwellen emittiert werden sollen im Falle eines MEMS-Lautsprechers.

Die Erfindung soll im Folgenden unter Verweis auf Figuren und Beispiele erläutert werden. Die Beispiele und Abbildungen dienen der Illustration bevorzugter Ausführungsformen der Erfindung, ohne diese zu beschränken.

### FIGUREN

### Kurzbeschreibunq der Figuren

- **Fig. 1**: Schematische Darstellung von bevorzugten Verfahrensschritten zur Herstellung eines MEMS-Wandlers
- **Fig. 2**: Weitere schematische Darstellung von bevorzugten Verfahrensschritten zur Herstellung eines MEMS-Wandlers
- **Fig. 3**: Weitere schematische Darstellung von bevorzugten Verfahrensschritten zur Herstellung eines MEMS-Wandler

### Detaillierte Beschreibung der Figuren

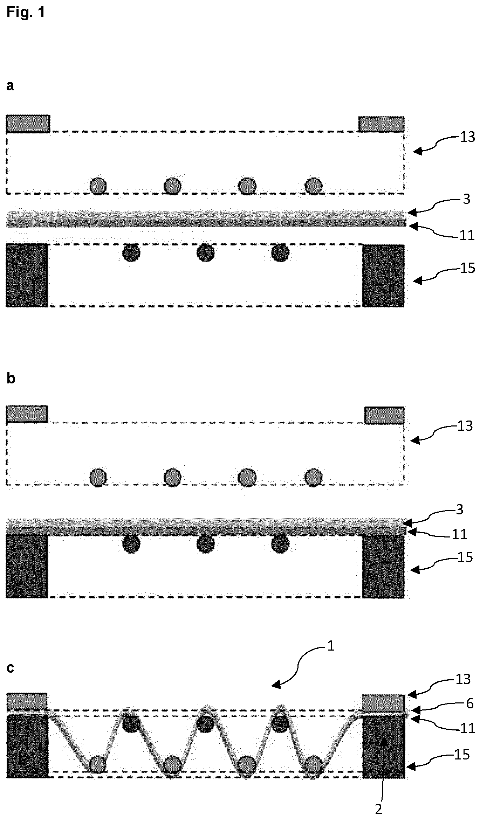

Fig. 1 zeigt eine schematische Darstellung von bevorzugten Verfahrensschritten.

In Fig. 1a ist eine erste Formgebungskomponente **13** und eine zweite Formgebungskomponente **15** dargestellt. Die erste Formgebungskomponente bzw. erste Kammstruktur **13** und die zweite Formgebungskomponente bzw. zweite Kammstruktur **15** sind als Kammstrukturen ausgebildet, d. h. sie umfassen Kammfinger **9**, die in der Darstellung allerdings aus bzw. in die Blattebene hineinzeigen.

Weiterhin ist das Aktuatormaterial in Form einer Polymerfolie **3** dargestellt sowie eine Lage umfassend ein mechanisches Stützmaterial **11.** Die Polymerfolie 3 wird auf das mechanische Stützmaterial **11** aufgebracht.

In Fig. 1b wird abgebildet, dass die Polymerfolie **3** und die Lage umfassend ein mechanisches Stützmaterial **11** auf die Kammfinger der zweiten Kammstruktur **15** aufgebracht wird.

In Fig. 1c wird gezeigt, dass die erste Kammstruktur **13** in Richtung der Polymerfolie **3** und der Lage umfassend das mechanische Stützmaterial **11** geführt wird. Dabei werden jeweilige Kammfinger der ersten Kammstruktur **13** in Leerbereiche der zweiten Kammstruktur **15** geführt. Mithin wird in einer Zusammenwirkung der ersten Kammstruktur **13** und der zweiten Kammstruktur **15** die Mäanderstruktur für eine Aktuatorlage **6** gebildet, wobei die Mäanderstruktur vertikale Abschnitte und horizontale Abschnitte aufweist.

Durch den finalen Abstand zwischen der ersten Kammstruktur **13** und der zweiten Kammstruktur **15,** insbesondere zwischen den Spitzen der Kammfinger, kann vorteilhaft die Länge der vertikalen Abschnitte der schwingfähigen Membran bestimmt werden. Ebenfalls wird durch die Form der beiden Kammstrukturen **13**, **15** die Form der Aktuatorlage und damit der schwingfähigen Membran reguliert werden. Der finale Abstand zwischen der ersten Kammstruktur **13** und der zweiten Kammstruktur **15** wird durch einen Führungsweg der Kammstrukturen **13**, **15** bestimmt.

Die Polymerfolie 3 wird vorzugsweise an den Endbereichen der Kammerstruktur **13** und/oder **15** fixiert, sodass durch das Zusammenwirkender ersten Kammstruktur **13** mit der zweiten Kammstruktur **15** die Polymerfolie **3** gestreckt bzw. gedehnt wird, um eine entsprechende Mäanderstruktur zu erhalten wird.

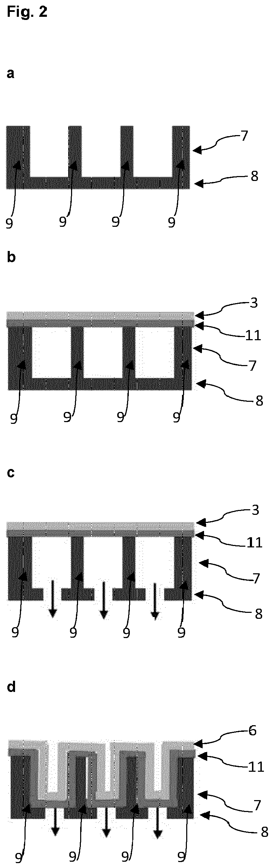

Fig. 2 zeigt weitere bevorzugte Verfahrensschritte zur Ausbildung der Mäanderstruktur.

In Fig. 2a wird eine Formgebungskomponente **7** in Form einer Kammstruktur **7** dargestellt, die Kammfinger **9** aufweist. Durch die Struktur der Kammfinger **9** kann vorteilhaft besonders einfach die Mäanderstruktur für die Struktur der schwingfähigen Membran erlangt werden.

In Fig. 2b werden das Aktuatormaterial in Form einer Polymerfolie **3** sowie die Lage umfassend das mechanische Stützmaterial **11** bereitgestellt, wobei diese auf die Kammfinger **9** der Kammstruktur **7** aufgebracht werden.

In Fig. 2c ist zu erkennen, dass die Kammstruktur Öffnungen aufweist, wobei die an einem Hauptstrang **8** der Kammstruktur **7** ausgebildet sind, auf die die Kammfinger **9** angeordnet sind. Durch die eingezeichneten Pfeile wird die Applizierung eines Niederdrucks dargestellt, sodass Teilbereiche der Polymerfolie **3** und der Lage umfassend das mechanische Stützmaterial **11** gestreckt werden.

Während der Applikation des Niederdrucks liegt die Polymerfolie **3** an den Endbereichen der Kammerstruktur **7** fixiert vor, sodass eine entsprechend Dehnung der Polymerfolie **3** bewirkt wird. Vorzugsweise erfolgt eine Verstreckung der gesamten Polymerfolie entlang einer Dimension der hintereinander aufgereihten Kammfinger **9**, wobei der Grad der Verstreckung bzw. Dehnung durch die Höhe und/oder Dauer des applizierten Niederdruckes eingestellt werden kann.

Insbesondere wird über jede Öffnung ein im Wesentlichen identischer Niederdruck appliziert, um eine möglichst gleichförmige mechanische Verstreckung der Polymerfolie **3** zu bewirken. Auf die mechanische Verstreckung durch den Einsatz eines Niederdrucks kann durch die Größe der Öffnungen und/oder dem Wert des Niederdruck Einfluss genommen werden. Je geringer der Druck und/oder desto größer die Öffnung, desto schneller erfolgt die mechanische Verstreckung der Polymerfolie **3**, um die Mäanderstruktur bereitzustellen.

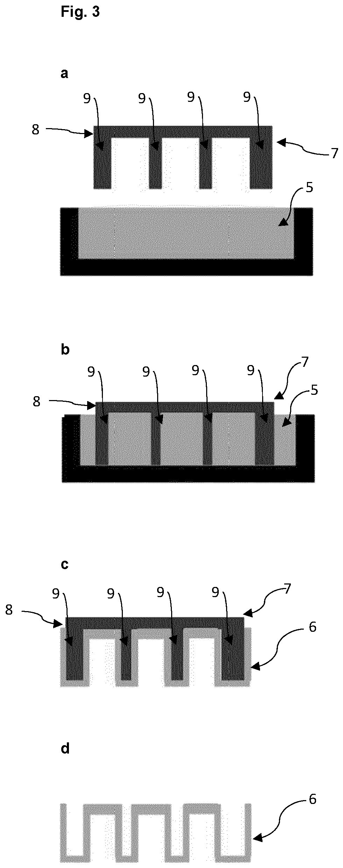

Fig. 3 zeigt eine weitere schematische Darstellung von bevorzugten Verfahrensschritten.

In Fig. 3a wird eine Polymerflüssigkeit **3** und die Formgebungskomponente **7** bereitgestellt, wobei die Formgebungskomponente **7** als Kammstruktur **7** umfassend Kammfinger **9** vorliegt.

In Fig. 3b ist zu sehen, dass die Kammstruktur **7** in die Polymerflüssigkeit **5** eingetaucht wird. Nach der Kontaktierung bzw. dem Eintauchen der Kammstruktur **7** in der Polymerflüssigkeit **5** werden die Polymere des Aktuatormaterials bzw. der Polyermerflüssigkeit **5** eine derartige Ausrichtung erfahren, sodass ein Dipolmoment der Polymere erhöht und piezoelektrische Eigenschaften des Aktuatormaterials verstärkt werden. Die Ausrichtung der Polymere der Polymerflüssigkeit **5** erfolgt durch das Eintauchen der Formgebungskomponente **7** in die Polymerflüssigkeit **5**.

In Fig. 3c wird gezeigt, dass an der Kammstruktur **7** die Polymerflüssigkeit **5** haften bleibt und zur Ausbildung der Aktuatorlage **6** als Mäanderstruktur umfassend vertikale und horizontale Abschnitte aushärtet.

Nach Ausbildung der Aktuatorlage **6** wird die Kammstruktur **7** entfernt, was beispielsweise durch ein Ätzverfahren und/oder eine thermische Behandlung erfolgen kann (vgl. Fig. 3d).

### LITERATUR

Iman Shahosseini, Elie LEFEUVRE, Johan Moulin, Marion Woytasik, Emile Martincic, et al. Electromagnetic MEMS Microspeaker for Portable Electronic Devices. Microsystem Technologies, Springer Verlag (Germany), 2013, pp.10. <hal-01103612>
F. Stoppel, C. Eisermann, S. Gu-Stoppel, D. Kaden, T. Giese and B. Wagner, NOVEL MEMBRANE-LESS TWO-WAY MEMS LOUDSPEAKER BASED ON PIEZOELECTRIC DUAL-CONCENTRIC ACTUATORS, Transducers 2017, Kaohsiung, TAIWAN, June 18-22, 2017.
Bert Kaiser, Sergiu Langa, Lutz Ehrig, Michael Stolz, Hermann Schenk, Holger Conrad, Harald Schenk, Klaus Schimmanz und David Schuffenhauer, Concept and proof for an all-silicon MEMS microspeaker utilizing air chambers Microsystems & Nanoengineering volume 5, Article number: 43 (2019).
Da Silva, Aline Bruna, et al. Effect of drawing on the dielectric properties and polarization of pressed solution cast β-PVDF films. Journal of materials science 45.15 (2010): 4206-4215.
Gade, Harshal, Sreevalli Bokka, and George G. Chase. Polarization treatments of electrospun PVDF fiber mats. Polymer212 (2021): 123152.

### BEZUGSZEICHENLISTE

- 1: Schwingfähige Membran
- 3: Polymerfolie
- 5: Polymerflüssigkeit
- 6: Aktuatorlage
- 7: Formgebungskomponente, bevorzugt als Kammstruktur
- 8: Hauptstrang
- 9: Kammfinger
- 11: Lage umfassend ein mechanisches Stützmaterial, Stützlage
- 13: Erste Formgebungskomponente, bevorzugt als erste Kammstruktur
- 15: Zweite Formgebungskomponente, bevorzugt als zweite Kammstruktur

## Patentansprüche

1. Verfahren zur Herstellung eines MEMS-Wandlers zur Interaktion mit einem Volumenstrom eines Fluids umfassend
- einen Träger
- eine schwingfähige Membran (1) zur Erzeugung oder Aufnahme von Druckwellen des Fluids in einer vertikalen Richtung, wobei die schwingfähige Membran von dem Träger gehalten wird,
die schwingfähige Membran (1) eine Mäanderstruktur mit vertikalen Abschnitten und horizontalen Abschnitten aufweist, wobei die vertikalen Abschnitte im Wesentlichen parallel zur vertikalen Richtung ausgebildet sind und die horizontalen Abschnitte die vertikalen Abschnitte miteinander verbinden, und wobei die schwingfähige Membran (1) mindestens eine Aktuatorlage (6) aus einem Aktuatormaterial umfasst und mit mindestens einer Elektrode kontaktiert vorliegt, sodass durch Ansteuerung der mindestens einen Elektrode die vertikalen Abschnitte zu horizontalen Schwingungen angeregt werden können oder sodass bei Anregung der vertikalen Abschnitte zu horizontalen Schwingungen an der mindestens einen Elektrode ein elektrisches Signal erzeugt werden kann
**dadurch gekennzeichnet, dass**
das Verfahren folgende Schritte umfasst:
a) Bereitstellung mindestens einer Formgebungskomponente (7, 13, 15) zur Ausbildung der schwingfähige Membran (1) mit der Aktuatorlage (6) in Form einer Mäanderstruktur,
b) Bereitstellung eines Aktuatormaterials umfassend Polymere, wobei das Aktuatormaterial in Form einer Polymerfolie (3) oder einer Polymerflüssigkeit (5) vorliegt,
c) Kontaktierung der Formgebungskomponente (7, 13, 15) mit dem Aktuatormaterial für eine Formausgestaltung der Aktuatorlage (6), wobei während der Kontaktierung der Formgebungskomponente mit dem Aktuatormaterial die Polymere des Aktuatormaterials ausgerichtet und/oder verstreckt werden, sodass ein Dipolmoment der Polymere erhöht und piezoelektrische Eigenschaften des Aktuatormaterials verstärkt werden.

2. Verfahren nach dem vorherigen Anspruch
**dadurch gekennzeichnet, dass**
das Aktuatormaterial ausgewählt ist aus einer Gruppe umfassend ein piezoelektrisches Material, ein piezoelektrisches Polymermaterial und/oder elektroaktive Polymere (EAP), wobei bevorzugt das Aktuatormaterial ein piezoelektrisches Polymermaterial ist, wobei besonders bevorzugt das piezoelektrische Polymermaterial ausgewählt ist aus einer Gruppe umfassend Polyvinylidenfluorid (PVDF), Polyvinylidenfluorid-Co-Trifluorethylen) (PVDF-TrFE) und/oder Poly-L-Milchsäure (PLLA).

3. Verfahren nach einem oder mehreren der vorherigen Ansprüche
**dadurch gekennzeichnet, dass**
die Aktuatorlage (6) eine relative Permittivität εᵣ von 1 - 15, bevorzugt von 5 - 15, besonders bevorzugt von 7 - 12 aufweist und/oder
die Aktuatorlage (6) piezoelektrische Ladungskoeffizienten von 1 - 50 pC/N, bevorzugt zwischen 1 - 5 pC/N, besonders bevorzugt von 5 - 30 pC/N, ganz besonders bevorzugt von 30 - 50 pC/N aufweist.

4. Verfahren nach einem oder mehreren der vorherigen Ansprüche
**dadurch gekennzeichnet, dass**
das Aktuatormaterial in Form der Polymerfolie (3) bereitgestellt wird, wobei mittels der Formgebungskomponente (7, 13, 15) eine mechanische Streckung der Polymerfolie zur Ausbildung einer Aktuatorlage (6) in die Mäanderstruktur umfassend die vertikale Abschnitte und die horizontalen Abschnitten ausgeführt wird.

5. Verfahren nach dem vorherigen Anspruch
**dadurch gekennzeichnet, dass**
die Formgebungskomponente (7, 13, 15) eine Kammstruktur (7, 13, 15) umfassend Kammfingern (9) aufweist.

6. Verfahren nach einem oder mehreren der vorherigen Ansprüche
**dadurch gekennzeichnet, dass**
die Formgebungskomponente (7, 13, 15) eine Kammstruktur (7) umfassend Kammfinger (9) umfasst sowie die Kammstruktur (7) Öffnungen aufweist, wobei das Aktuatormaterial als Polymerfolie (3) auf die Kammfinger (9) der Kammstruktur (7) aufgebracht wird und ein Niederdruck, bevorzugt ein Vakuum, über die Öffnungen appliziert wird, sodass Teilbereiche der Polymerfolie (3) in Richtung der Öffnungen mechanisch gestreckt werden, sodass eine Mäanderstruktur gebildet wird.

7. Verfahren nach einem oder mehreren der vorherigen Ansprüche
**dadurch gekennzeichnet, dass**
das Aktuatormaterial als Polymerfolie (3) auf einer ersten Kammstruktur (13) aufgebracht wird, wobei eine zweite Kammstruktur (15) in Richtung der Polymerfolie (3) geführt wird und jeweilige Kammfinger der ersten Kammstruktur (13) und der zweiten Kammstruktur (15) in Leerbereiche geführt werden, sodass in einer Zusammenwirkung der ersten Kammstruktur (13) und der zweiten Kammstruktur (15) die Mäanderstruktur umfassend die vertikale Abschnitte und die horizontale Abschnitte gebildet wird.

8. Verfahren nach einem oder mehreren der vorherigen Ansprüche
**dadurch gekennzeichnet, dass**
das Aktuatormaterial in Form der Polymerfolie (3) bereitgestellt wird, auf welcher zusätzlich mindestens eine Lage umfassend ein mechanisches Stützmaterial (11) und/oder ein leitfähiges Material aufgebracht vorliegt, wobei die Lage umfassend das mechanische Stützmaterial (11) und/oder die Lage umfassend ein leitfähiges Material ebenfalls eine mechanische Streckung bei der Kontaktierung mit der Formgebungskomponente (7, 13, 15) erfährt.

9. Verfahren nach einem oder mehreren der vorherigen Ansprüche
**dadurch gekennzeichnet, dass**
nach einer mechanischen Streckung das Aktuatormaterial in Form der Polymerfolie (3) zusätzlich mit mindestens einer Lage umfassend ein mechanisches Stützmaterial (11) und/oder ein leitfähiges Material beschichtet wird.

10. Verfahren nach einem oder mehreren der vorherigen Ansprüche
**dadurch gekennzeichnet, dass**
die schwingfähige Membran (1) eine Lage umfassend ein leitfähiges Material umfasst, wobei das leitfähige Material ausgewählt ist aus einer Gruppe umfassend Platin, Wolfram, (dotiertes) Zinnoxid, monokristallines Silizium, Polysilizium, Molybdän, Titan, Tantal, Titan-Wolfram Legierung, Metallsilizid, Aluminium, Graphit, Kupfer,
wobei bevorzugt das leitfähige Material ein superelastisches Metall ist,
wobei besonders bevorzugt das leitfähige Material eine Faserverstärkung aufweist, wobei für die Faserverstärkung das leitfähige Material Fasern aufweist, wobei ganz besonders bevorzugt die Fasern Kohlenstoff umfassen.

11. Verfahren nach einem oder mehreren der vorherigen Ansprüche
**dadurch gekennzeichnet, dass**
die schwingfähige Membran (1) eine Lage umfassend eines mechanisches Stützmaterial (11) umfasst, wobei das mechanisches Stützmaterial ausgewählt ist aus einer Gruppe umfassend monokristallines Silizium, polykristallines Silizium und/oder dotiertes polykristallines Silizium.

12. Verfahren nach einem oder mehreren der vorherigen Ansprüche
**dadurch gekennzeichnet, dass**
das Aktuatormaterial als Polymerflüssigkeit (5) bereitgestellt wird und die Formgebungskomponente (7, 13, 15) in die Polymerlüssigkeit (5) eingetaucht wird, wobei nach der Kontaktierung der Formgebungskomponente (7, 13, 15) mit der Polymerflüssigkeit (5) die Polymere des Aktuatormaterials eine derartige Ausrichtung erfahren, dass ein Dipolmoment der Polymere erhöht und piezoelektrische Eigenschaften des Aktuatormaterials verstärkt werden,
wobei bevorzugt die Formgebungskomponente (7, 13, 15) eine Kammstruktur (7) umfassend Kammfinger (9) umfasst.

13. Verfahren nach einem oder mehreren der vorherigen Ansprüche
**dadurch gekennzeichnet, dass**
nach einer Kontaktierung der Formgebungskomponente (7, 13, 15) mit der Polymerflüssigkeit (5) die Polymerflüssigkeit (5) an der Formgebungskomponente haften bleibt und aushärtet zur Ausbildung der Aktuatorlage umfassend vertikale und horizontale Abschnitte,
wobei bevorzugt nach der Ausbildung der Aktuatorlage (6), die Aktuatorlage (6) mit einer Lage umfassend ein leitfähiges Material und/oder ein mechanisches Stützmaterial (11) beschichtet wird.

14. Verfahren nach einem oder mehreren der vorherigen Ansprüche
**dadurch gekennzeichnet, dass**
zumindest ein Teilabschnitt der Formgebungskomponente (7, 13, 15), bevorzugt ein Gesamtabschnitt, nach einer Kontaktierung mit dem Aktuatormaterial (5) entfernt wird, bevorzugt durch ein Ätzverfahren und/oder durch eine thermische Behandlung.

15. MEMS-Wandler zur Interaktion mit einem Volumenstrom eines Fluids herstellbar gemäß einem Verfahren nach einem oder mehreren der vorherigen Ansprüche.
